(19) 

Europäisches Patentamt

European Patent Office

Office européen des brevets

(11) **EP 4 657 127 A1**

(12) **EUROPEAN PATENT APPLICATION**
published in accordance with Art. 153(4) EPC

(43) Date of publication:
03.12.2025 Bulletin 2025/49

(21) Application number: 23918677.8

(22) Date of filing: 26.12.2023

(51) International Patent Classification (IPC):
*G02B 5/20* [(2006.01)]  *C09K 11/08* [(2006.01)]
*C09K 11/59* [(2006.01)]  *C09K 11/62* [(2006.01)]
*C09K 11/64* [(2006.01)]  *C09K 11/80* [(2006.01)]
*G01J 3/10* [(2006.01)]  *G01N 21/01* [(2006.01)]

(52) Cooperative Patent Classification (CPC):
C09K 11/08; C09K 11/59; C09K 11/62; C09K 11/64;
C09K 11/77; G01J 3/10; G01N 21/01; G02B 5/20

(86) International application number:
PCT/JP2023/046790

(87) International publication number:
WO 2024/157723 (02.08.2024 Gazette 2024/31)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(30) Priority: 27.01.2023 JP 2023010886

(71) Applicant: Panasonic Intellectual Property
Management Co., Ltd.
Kadoma-shi, Osaka 571-0057 (JP)

(72) Inventors:
• SHIGITANI, Ryosuke
  Kadoma-shi, Osaka 571-0057 (JP)

• ABE, Takeshi
  Kadoma-shi, Osaka 571-0057 (JP)
• NITTA, Mitsuru
  Kadoma-shi, Osaka 571-0057 (JP)
• IWATA, Koki
  Kadoma-shi, Osaka 571-0057 (JP)
• FUJIWARA, Chigusa
  Kadoma-shi, Osaka 571-0057 (JP)
• OSHIO, Shozo
  Kadoma-shi, Osaka 571-0057 (JP)

(74) Representative: Müller-Boré & Partner
Patentanwälte PartG mbB
Friedenheimer Brücke 21
80639 München (DE)

(54) **NEAR-INFRARED LIGHT EMITTING DEVICE, SPECTROSCOPIC DEVICE, AND SPECTROSCOPY**

(57) A near-infrared light emitting device (100) is configured to satisfy a relationship of $0.853M_{VIS} \leq M_{NIR} < 1.147M_{VIS}$, the $M_{VIS}$ is a ratio of $I_{max-VIS-150}$ to $I_{max-VIS-30}$, the $I_{max-VIS-30}$ is a maximum fluorescence intensity of a visible fluorescence component when a temperature of a wavelength converter (2) is 30°C, the $I_{max-VIS-150}$ is a maximum fluorescence intensity of the visible fluorescence component when a temperature of the wavelength converter (2) is 150°C, the $M_{NIR}$ is a ratio of $I_{max-NIR-150}$ to $I_{max-NIR-30}$, the $I_{max-NIR-30}$ is a maximum fluorescence intensity of a near-infrared fluorescence component when a temperature of the wavelength converter (2) is 30°C, and the $I_{max-NIR-150}$ is a maximum fluorescence intensity of the near-infrared fluorescence component when a temperature of the wavelength converter (2) is 150°C.

FIG. 4

**Description**

TECHNICAL FIELD

The present invention relates to a near-infrared light emitting device, and a spectroscopic apparatus and a spectroscopy using the near-infrared light emitting device.

BACKGROUND ART

A near-infrared light emitting device having a solid-state light emitting element and a wavelength converter has been known in the past as a light emitting device. Patent Literature 1 discloses this kind of near-infrared light emitting device, and the wavelength converter includes a visible phosphor which emits fluorescent light having a maximum fluorescence intensity in a wavelength range of visible light, and a near-infrared phosphor which emits fluorescent light having a maximum fluorescence intensity in a wavelength range of near-infrared light. This kind of near-infrared light emitting device has the advantage of achieving both normal observation using visible light and special observation using near-infrared light.

CITATION LIST

PATENT LITERATURE

Patent Literature 1: WO 2020/217671

SUMMARY OF INVENTION

However, the temperature quenching of a general near-infrared phosphor used in the past is larger than the temperature quenching of a visible phosphor. Therefore, the temperature of a phosphor rises due to a solid-state light emitting element being turned on, and due to this, there is a risk that the intensity of a near-infrared fluorescence component decreases, relative to the intensity of a visible fluorescence component. Therefore, a certain amount of time may be required until the intensity of output light emitted by a near-infrared light emitting device is stabilized.

The present invention is devised in view of the problem of the prior art. An object of the present invention is to provide a near-infrared light emitting device which has a small change in the shape of the spectral distribution due to the temperature rise of a wavelength converter, and a spectroscopic apparatus and a spectroscopy using the near-infrared light emitting device.

In order to solve the above problem, a near-infrared light emitting device according to an aspect of the present invention includes: a solid-state light emitting element; and a wavelength converter that includes a visible phosphor which emits visible fluorescent light having a maximum fluorescence intensity in a wavelength range of visible light, and a near-infrared phosphor which emits near-infrared fluorescent light having a maximum fluorescence intensity in a wavelength range of near-infrared light. The near-infrared light emitting device emits output light including the visible fluorescent light and the near-infrared fluorescent light. The output light includes a visible fluorescence component having a spectral intensity in a wavelength range of visible light, and a near-infrared fluorescence component having a spectral intensity in a wavelength range of near-infrared light. The near-infrared light emitting device is configured to satisfy a relationship of $0.853 M_{VIS} \leq M_{NIR} < 1.147 M_{vis}$. The $M_{VIS}$ is a ratio of $I_{max\text{-}VIS\text{-}150}$ to $I_{max\text{-}VIS\text{-}30}$. The $I_{max\text{-}VIS\text{-}30}$ is a maximum fluorescence intensity of the visible fluorescence component when a temperature of the wavelength converter is 30°C. The $I_{max\text{-}VIS\text{-}150}$ is a maximum fluorescence intensity of the visible fluorescence component when a temperature of the wavelength converter is 150°C. The $M_{NIR}$ is a ratio of $I_{max\text{-}NIR\text{-}150}$ to $I_{max\text{-}NIR\text{-}30}$. The $I_{max\text{-}NIR\text{-}30}$ is a maximum fluorescence intensity of the near-infrared fluorescence component when a temperature of the wavelength converter is 30°C. The $I_{max\text{-}NIR\text{-}150}$ is a maximum fluorescence intensity of the near-infrared fluorescence component when a temperature of the wavelength converter is 150°C.

A spectroscopic apparatus according to an aspect of the present invention includes the near-infrared light emitting device.

A spectroscopy according to an aspect of the present invention uses the near-infrared light emitting device.

BRIEF DESCRIPTION OF DRAWINGS

[FIG. 1] FIG. 1 is a schematic diagram showing an example of a structure of a near-infrared light emitting device according to one embodiment.

[FIG. 2] FIG. 2 is a schematic diagram showing an example of a structure of a spectroscopic apparatus according to one embodiment.

[FIG. 3] FIG. 3 is a schematic diagram showing an example of a structure of a spectroscopic apparatus according to another embodiment.

[FIG. 4] FIG. 4 shows the spectral distribution of output light emitted from a near-infrared light emitting device of the present example.

[FIG. 5] FIG. 5 is a graph showing the temperature quenching of a visible phosphor and a near-infrared phosphor used for the evaluation.

[FIG. 6] FIG. 6 shows fluorescent spectrums of mixed phosphors at each temperature according to Example 2.

[FIG. 7] FIG. 7 shows fluorescent spectrums of mixed phosphors at each temperature according to Example 3.

[FIG. 8] FIG. 8 shows fluorescent spectrums of mixed phosphors at each temperature according to Example 4.

[FIG. 9] FIG. 9 shows fluorescent spectrums of mixed phosphors at each temperature according to Example 5.

[FIG. 10] FIG. 10 shows fluorescent spectrums of mixed phosphors at each temperature according to Example 6.

[FIG. 11] FIG. 11 shows fluorescent spectrums of mixed phosphors at each temperature according to Example 7.

[FIG. 12] FIG. 12 shows fluorescent spectrums of mixed phosphors at each temperature according to Comparative Example 1.

[FIG. 13] FIG. 13 shows fluorescent spectrums of mixed phosphors at each temperature according to Comparative Example 2.

[FIG. 14] FIG. 14 shows X-ray diffraction patterns of an $LiGa_5O_8:Cr^{3+}$ near-infrared phosphor and an $LiGa_5O_8:Cr^{3+}$ deep red phosphor according to Comparative Example 1, and an X-ray diffraction pattern of $LiGa_5O_8$ registered in an inorganic crystal structure database (ICSD).

[FIG. 15] FIG. 15 shows fluorescent spectrums of the $LiGa_5O_8:Cr^{3+}$ near-infrared phosphor and the $LiGa_5O_8:Cr^{3+}$ deep red phosphor.

[FIG. 16] FIG. 16 is the graph showing the relationship between the temperature of the $LiGa_5O_8:Cr^{3+}$ near-infrared phosphor and the $LiGa_5O_8:Cr^{3+}$ deep red phosphor, and maximum fluorescence intensities of fluorescent light emitted by the phosphors.

DESCRIPTION OF EMBODIMENTS

A near-infrared light emitting device, a spectroscopic apparatus, and a spectroscopy according to embodiments herein will be described in detail below with reference to the drawings. The dimensional proportions of the drawings are exaggerated for illustrative purposes and may differ from the actual proportions.

[Near-infrared light emitting device]

As described above, the temperature quenching of the general near-infrared phosphor used in the past is larger than the temperature quenching of the visible phosphor. Information that a near-infrared phosphor exhibits relatively large temperature quenching may be an essential issue of the near-infrared phosphor, and this may be due to optical properties. A general description of study of the cause of the issue will be made below.
A wavelength converter of a device investigated exclusively for practical application absorbs blue light. Then, the absorbed blue light is converted into visible light and near-infrared light having a longer wavelength than the absorbed blue light by a visible phosphor (especially $Ce^{3+}$ activated phosphor or $Eu^{2+}$ activated phosphor) and a near-infrared phosphor

(especially $Cr^{3+}$ activated phosphor), respectively which are included in the wavelength converter.

Therefore, fluorescent light of the near-infrared phosphor has a larger Stokes shift (energy difference between light absorption and fluorescence emission) than fluorescent light of the visible phosphor. This means that the fluorescent light of the near-infrared phosphor becomes wavelength converted light which is due to the electron energy transition with a larger Franck-Condon offset (shift of equilibrium position between ground state and excited state). It is estimated that since an equilibrium position of an excited state of a fluorescent ion of a near-infrared phosphor such as $Cr^{3+}$ is close to a ground state, there is a possibility that temperature quenching easily occurs, for example.

Therefore, in the present disclosure, the temperature quenching of a visible phosphor and the temperature quenching of a near-infrared phosphor are set to be in a predetermined range. As a result, it has been found that the spectral distribution of output light including visible light by the visible phosphor and near-infrared fluorescent light by the near-infrared phosphor is stable, relative to the temperature of a wavelength converter.

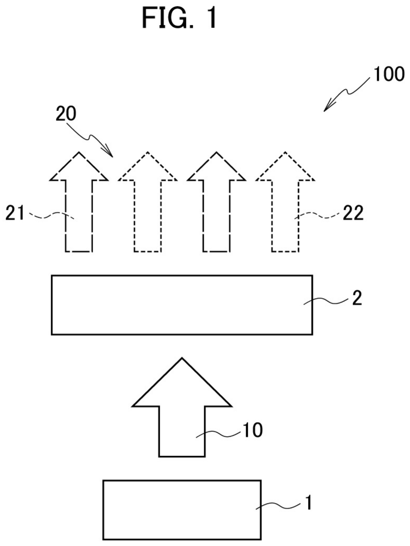

A near-infrared light emitting device 100 according to the present embodiment will be described below with reference to FIG. 1. FIG. 1 is a schematic diagram showing an example of the near-infrared light emitting device 100 according to one embodiment. As shown in FIG. 1, the near-infrared light emitting device 100 includes a solid-state light emitting element 1 and a wavelength converter 2. The wavelength converter 2 includes a visible phosphor and a near-infrared phosphor. The visible phosphor emits visible fluorescent light 22 having a maximum fluorescence intensity in a wavelength range of visible light. The near-infrared phosphor emits near-infrared fluorescent light 21 having a maximum fluorescence intensity in a wavelength range of near-infrared light. The near-infrared light emitting device 100 is configured to emit output light 20 including the visible fluorescent light 22 and the near-infrared fluorescent light 21. The output light 20 includes a visible fluorescence component and a near-infrared fluorescence component. The visible fluorescence component has a spectral intensity in a wavelength range of visible light, and the near-infrared fluorescence component has a spectral intensity in a wavelength range of near-infrared light.

The solid-state light emitting element 1 is configured to emit primary light 10. The output light 20 may include the primary light 10. It is preferable that the primary light 10 is blue light having a maximum fluorescence intensity in a blue wavelength range of 435 nm or more and less than 480 nm, particularly in a blue wavelength range of 440 nm or more and less than 470 nm. In this way, a visible phosphor and a near-infrared phosphor can be excited using only one type of solid-state light emitting element 1. Therefore, the near-infrared light emitting device 100 is advantageous in simplifying a lighting circuit. In addition, if the primary light 10 is blue light having a relatively short wavelength and can excite a visible phosphor and a near-infrared phosphor, it is possible to increase technological options of the visible phosphor. That is, the phosphors can be used in combination with any of a green phosphor, a yellow phosphor, an orange phosphor, and a red phosphor, which will be described later.

The solid-state light emitting element 1 converts electricity into light, and when power is supplied thereto and the solid-state light emitting element 1 is driven, the solid-state light emitting element 1 converts the supplied electric energy into light energy. Then, the converted light energy is emitted from a light extraction surface as the primary light 10. Typical examples of the solid-state light emitting element 1 include a light emitting diode (LED) and a laser diode (LD).

The wavelength converter 2 includes a visible phosphor and a near-infrared phosphor. The visible phosphor may be configured to be excited by the primary light 10 emitted by the solid-state light emitting element 1. Further, the near-infrared phosphor may be configured to be excited by the primary light 10 emitted by the solid-state light emitting element 1.

The visible phosphor emits the visible fluorescent light 22 having a maximum fluorescence intensity in a wavelength range of visible light. The visible phosphor may be at least one phosphor selected from the group consisting of a green phosphor which emits light having a maximum fluorescence intensity in a wavelength range of 490 nm or more and less than 570 nm, a yellow phosphor which emits light having a maximum fluorescence intensity in a wavelength range of 570 nm or more and less than 585 nm, an orange phosphor which emits light having a maximum fluorescence intensity in a wavelength range of 585 nm or more and less than 620 nm, and a red phosphor which emits light having a maximum fluorescence intensity in a wavelength range of 620 nm or more and less than 780 nm. This can adjust the spectral distribution of a visible fluorescence component. Therefore, it is possible to adjust a visible fluorescence component of the output light 20 emitted from the near-infrared light emitting device 100 according to a usage application.

The visible phosphor may be at least one phosphor selected from the group consisting of a $Ce^{3+}$ activated garnet phosphor, $Eu^{2+}$ activated alkaline earth metal nitride silicate, and $Eu^{2+}$ activated alkaline earth metal nitride aluminosilicate. These visible phosphors have high application achievements as phosphors for LED lighting. Therefore, procurement of these visible phosphors is easy, and additionally reliability and handling of these visible phosphors are assured. Therefore, it is possible to provide the near-infrared light emitting device 100 having these kinds of visible phosphors.

Examples of the $Ce^{3+}$ activated garnet phosphor include a phosphor represented by a general formula $RE_3Al_2(AlO_4)_3$:$Ce^{3+}$, $Ca_3Sc_2(SiO_4)_3$:$Ce^{3+}$, $Y_3Ga_2(AlO_4)_3$:$Ce^{3+}$, and solid solutions thereof. In the above general formula, RE refers to a rare earth element, and is at least one rare earth selected from the group consisting of Sc, Y, La, Tb, Gd, and Lu, for example. Specific examples of the phosphor represented by the general formula $RE_3Al_2(AlO_4)_3$:$Ce^{3+}$ include $Lu_3Al_2(AlO_4)_3$:$Ce^{3+}$, $Y_3Al_2(AlO_4)_3$:$Ce^{3+}$(YAG), and $(Y, Gd)_3Al_2(AlO_4)_3$:$Ce^{3+}$.

Examples of the $Eu^{2+}$ activated alkaline earth metal nitride silicate include $Sr_2Si_5N_8$:$Eu^{2+}$, $Ca_2Si_5N_8$:$Eu^{2+}$, and

solid solutions thereof.

An example of the $Eu^{2+}$ activated alkaline earth metal nitride aluminosilicate is a phosphor represented by a general formula $MAlSiN_3:Eu^{2+}$. In the general formula, M refers to magnesium or an alkaline earth metal, and is at least one metal element selected from the group consisting of Mg, Ca, Sr, and Ba, for example. Specific examples of the $Eu^{2+}$ activated alkaline earth metal nitride aluminosilicate include $CaAlSiN_3:Eu^{2+}$(CASN), $SrAlSiN_3:Eu^{2+}$, (Sr, Ca)AlSi-$N_3:Eu^{2+}$(SCASN), and solid solutions thereof.

From thereamong, it is preferable that the visible phosphor contains at least one phosphor selected from the group consisting of YAG, CASN, and SCASN.

A near-infrared phosphor emits the near-infrared fluorescent light 21 having a maximum fluorescence intensity in a wavelength range of near-infrared light. The near-infrared fluorescent light 21 may have a spectral intensity at least over an entire wavelength range of 700 nm or more and 1000 nm or less. This kind of spectral distribution is suitable for detecting characteristic absorption bands of N-H stretching vibration, C-H stretching vibration, and O-H stretching vibration by means of a spectroscopy. In a preferred form, the spectral intensity of a wavelength of 1000 nm of the spectral distribution is larger than the spectral intensity of a wavelength of 700 nm. Further, in a preferred form, fluorescent light is emitted, in which the ratio of near-infrared components at a wavelength longer than a wavelength of 750 nm, more preferably a wavelength of 780 nm, is larger than the ratio of light components at a wavelength shorter than the wavelengths. This kind of spectral distribution is more suitable for the near-infrared light emitting device 100 for infrared spectroscopy.

The near-infrared fluorescent light 21 may have a maximum fluorescence intensity in a wavelength range of 800 nm or more and less than 900 nm. This kind of near-infrared fluorescent light 21 can be emitted using near-infrared phosphors which exhibit fluorescence characteristics of extremely low temperature quenching, such as a $LiGa_5O_8:Cr^{3+}$ near-infrared phosphor and a near-infrared phosphor similar to this, for example. Therefore, the wavelength converter 2 is configured by combining the near-infrared phosphors with visible phosphors with low temperature quenching, such as a $Ce^{3+}$ activated garnet phosphor for LED lighting and an $Eu^{2+}$ activated alkaline earth metal nitride aluminosilicate phosphor for LED lighting, and it is possible to provide the near-infrared light emitting device 100 having an advantageous form, for example. The near-infrared fluorescent light 21 preferably has a maximum fluorescence intensity in a wavelength range of 800 nm or more and 860 nm or less.

It is preferable that the half width of a spectrum with a maximum fluorescence intensity of the near-infrared fluorescent light 21 is more than 180 nm. Therefore, even if one kind of near-infrared phosphor is used and several kinds of near-infrared phosphors are not used, it is possible to obtain a near-infrared component having the spectral distribution over a wide wavelength range of 700 to 1000 nm. Therefore, it is possible to reduce a risk that the shape of the spectral distribution of the near-infrared fluorescent light 21 or a near-infrared fluorescence component changes due to the temperature quenching difference when different kinds of near-infrared phosphors are used. The half width of the spectrum of the near-infrared fluorescent light 21 may be 180 nm or more and 240 nm or less, or 200 nm or more and 220 nm or less.

The near-infrared phosphor may have at least a chromium ion which functions as a fluorescent ion and which is added to a crystal of an inorganic compound with a spinel crystal structure that is the same as a spinel crystal structure of a compound $LiGa_5O_8$. Whether the near-infrared phosphor has a spinel crystal structure which is the same as a spinel crystal structure of the compound $LiGa_5O_8$ can be determined by measuring an X-ray diffraction pattern by means of an X-ray diffraction method. Specifically, this means that an XRD pattern of the near-infrared phosphor is substantially the same as an XRD pattern of the compound $LiGa_5O_8$ (registration number: 33716) registered in an ICSD.

The crystal may contain an alkali metal of a group 1 element, at least one of a group 13 element and scandium, and oxygen. That is, when the near-infrared phosphor is represented by a chemical formula $A_y(D_{1-x}Cr_x)_5O_8$, A may mainly contain an alkali metal, and D may mainly contain at least one of a group 13 element and scandium. D may mainly contain a group 13 element.

A mainly containing an alkali metal means that A contains an alkali metal in an amount of 75 mol% or more. A may contain an alkali metal in an amount of 90 mol% or more, in an amount of 95 mol% or more, or in an amount of 100 mol%. Further, D mainly containing at least one of a group 13 element and scandium means that D contains at least one of a group 13 element and scandium in an amount of 75 mol% or more. D may contain at least one of a group 13 element and scandium in an amount of 90 mol% or more, in an amount of 95 mol% or more, or in an amount of 100 mol%.

The alkali metal is preferably at least one element selected from the group consisting of Li, Na, K, Rb, and Cs, and more preferably at least one of Li and K. The group 13 element is preferably at least one element selected from the group consisting of Al, Ga, and In, and more preferably Ga.

It is preferable that the amount of the alkali metal of the above crystal is small, relative to a stoichiometric composition. In other words, it is preferable that the crystal has a composition in which an element A is deficient relative to a stoichiometric composition of $A(D_{1-x}Cr_x)_5O_8$. In this way, a crystal with chemical properties similar to those of $LiGa_5O_8$ can be used as the near-infrared phosphor. Therefore, the near-infrared phosphor is expected to have unique fluorescence characteristics similar to fluorescence characteristics of the $LiGa_5O_8:Cr^{3+}$ near-infrared phosphor. Furthermore, when application is made to a spectroscopy, high-precision non-destructive measurement can be expected.

The near-infrared phosphor is represented by a general formula $A_y(D_{1-x}Cr_x)_5O_8$. A mainly contains an alkali metal, D mainly contains at least one of a group 13 element and scandium, and y is preferably less than 1. When y is less than 1, it is possible to obtain a near-infrared phosphor, in which the ratio of light emitting components of emission lines is small. The y is more preferably 0.90 or less, even more preferably 0.85 or less, and particularly preferably 0.83 or less. Further, y is preferably 0.70 or more. When y is 0.70 or more, it is less likely that the near-infrared phosphor and a $\beta$-$Ga_2O_3:Cr^{3+}$ phosphor having a different phase are present in a mixed state, and it becomes easy to obtain desired unique fluorescence characteristics. The y is more preferably 0.75 or more, and even more preferably 0.77 or more.

The crystal mainly contains $LiGa_5O_8$, and it is preferable that a part of Ga is substituted with Cr. Here, "the crystal mainly containing $LiGa_5O_8$" means that the crystal contains $LiGa_5O_8$ in an amount of 75 mol% or more, and it is preferable that the crystal contains $LiGa_5O_8$ in an amount of 90 mol% or more.

A phosphor represented by a general formula $LiGa_5O_8:Cr^{3+}$ (hereinafter referred to as $LiGa_5O_8:Cr^{3+}$ phosphor) has been conventionally known as a deep red phosphor, which emits a deep red fluorescence component of an emission line having a maximum fluorescence intensity in the vicinity of a wavelength range of 715 to 720 nm. However, after experimental production of several $LiGa_5O_8:Cr^{3+}$ phosphors and evaluation of fluorescence characteristics thereof, it was found that the $LiGa_5O_8:Cr^{3+}$ phosphors functioned as near-infrared phosphors when the $LiGa_5O_8:Cr^{3+}$ phosphors were experimentally produced under specific preparation and synthesis conditions. Further, it was also found that an example was present in which the $LiGa_5O_8:Cr^{3+}$ phosphors exhibited the following unique fluorescence characteristic as the near-infrared phosphors.

(1) The phosphor has a maximum fluorescence intensity (fluorescence peak) in a wavelength range of 800 nm or more and 900 nm or less, such as the vicinity of a wavelength range of 830 nm, for example.

(2) The phosphor has a fluorescence component over a wide wavelength range of 700 to 1000 nm.

(3) A fluorescent spectrum is very wide, and the half width of a spectrum having a maximum fluorescence intensity is more than 180 nm.

(4) The temperature quenching is very small. (A maximum fluorescence intensity at a phosphor temperature of 150°C, relative to a maximum fluorescence intensity at a phosphor temperature of 30°C, is more than 90%.)

(5) The wavelength conversion efficiency (internal quantum efficiency) for converting an absorbed visible component into a near-infrared component is more than 80%, even though the phosphors experimentally produced are in an early stage of development.

In other words, it was found that the $LiGa_5O_8:Cr^{3+}$ phosphor does not mainly function as a deep red phosphor, but the $LiGa_5O_8:Cr^{3+}$ phosphor functions as a high-efficiency phosphor with very small temperature quenching, which emits a near-infrared component with a very wide fluorescent spectrum. These kinds of fluorescence characteristics, which are exceptional as fluorescence characteristics of a near-infrared phosphor, can be utilized for the near-infrared light emitting device 100. The near-infrared light emitting device 100 has a small change in the shape of the spectral distribution due to the temperature rise of the wavelength converter 2, and is suitable for a high-precision non-destructive inspection by means of a spectroscopy.

Table 1 summarizes fluorescence intensity maintenance ratios, internal quantum efficiencies, fluorescence peak wavelengths, and FWHMs of several near-infrared phosphors with reported examples, for the purpose of facilitating understanding of the present disclosure. Table 1 also shows fluorescence characteristics of the $LiGa_5O_8:Cr^{3+}$ near-infrared phosphor of Example 2 and the $LiGa_5O_8:Cr^{3+}$ deep red phosphor according to Comparative Example 1.

The fluorescence intensity maintenance ratio is a numerical value which is inversely correlated with temperature quenching, and is defined as a maximum fluorescence intensity at a phosphor temperature of 150°C, relative to a maximum fluorescence intensity at a phosphor temperature of 30°C. The internal quantum efficiency is the photon conversion efficiency for converting an absorbed visible component into a near-infrared component. A fluorescence peak wavelength is a wavelength in which a maximum fluorescence intensity is achieved. An FWHM is the half width of a spectrum having a maximum fluorescence intensity.

Further, for reference, Table 2 summarizes fluorescence characteristics of typical visible phosphors which are known as phosphors for LED lighting.

[Table 1]

| General formula | Fluorescence intensity maintenance ratio (%) | Internal quantum efficiency (%) | Fluorescence peak wavelength (nm) | FWHM (nm) |
|---|---|---|---|---|
| $Ca_3Sc_2Si_3O_{12}:Cr^{3+}$ | 97 | 92 | 780 | 100 |
| $LiGa_5O_8:Cr^{3+}$(near-infra-red) | 92 | 85 | 833 | 214 |
| $Y_2CaAl_4SiO_{12}:Cr^{3+}$ | 87 | 76 | 744 | 160 |
| $Gd_3(Sc,Ga)_2Ga_3O_{12}:Cr^{3+}$ | 86 | 91 | 756 | 120 |
| $Gd_3Ga_5O_{12}:Cr^{3+}$ | 84 | 89 | 745 | 96 |
| $NaScSi_2O_6:Cr^{3+}$ | 80 | - | 840 | 140 |
| $LaMgGa_{11}O_{19}:0.2Cr^{3+}$ | 80 | 83 | 775 | 150 |
| $Mg_3Ga_2GeO_8:Cr^{3+}$ | 79 | 87 | 790 | 175 |
| $LiInSi_2O_6:Cr^{3+}$ | 77 | 75 | 840 | 143 |
| $LaMgGa_{11}O_{19}:0.005Cr^{3+}$ | 73 | 84 | 715 | 60 |
| $(Ga,Sc)_2O_3:Cr^{3+}$ | 70 | 91 | 830 | 150 |
| $Na_3AlF_6:Cr^{3+}$ | 70 | 75 | 720 | - |
| $LiGa_5O_8:Cr^{3+}$ (deep red) | 61 | 54 | 719 | 4 |
| $Ca_2LuZr_2Al_3O_{12}:Cr^{3+}$ | 60 | 69 | 752 | 117 |
| $Ca_2LuScGa_2Ge_2Oi_2:Cr^{3+}$ | 59 | - | 810 | 150 |
| $InBO_3:Cr_{3+}$ | 55 | 62 | 825 | 138 |
| $La(Sc_{0.8}Ga_{0.2})_3B_4O_{12}:Cr^{3+}$ | 55 | 23 | 880 | 190 |
| $ScBO_3:Cr_{3+}$ | 51 | 65 | 800 | 120 |
| $La_2MgZrO_6:Cr^{3+}$ | 30 | - | 825 | 210 |
| $LiScP_2O_7:Cr^{3+}$ | 20 | 53 | 880 | 170 |
| $Cs_2AgInCl_6:Cr^{3+}$ | 20 | 22 | 1010 | 180 |
| $LiScP_2O_7:Cr^{3+}$ | 18 | 38 | 880 | 170 |
| $(Sr,Ca)Sc_2O_4:Cr^{3+}$ | 10 | - | 850 | 170 |

[Table 2]

| General formula | Fluorescence intensity maintenance ratio (%) | Internal quantum efficiency (%) | Fluorescence peak wavelength (nm) | FWHM (nm) |
|---|---|---|---|---|
| $Lu_3Al_2(AlO_4)_3:Ce^{3+}$ | 94 | 98 | 515 | 103 |
| $Y_3Al_2(AlO_4)_3:Ce^{3+}$ | 91 | 98 | 555 | 122 |
| $(Y,Gd)_3Al_2(AlO_4)_3:Ce^{3+}$ | 56 | 95 | 580 | 135 |
| $(Ba,Sr)_2SiO_4:Eu^{2+}$ | 66 | 92 | 530 | 70 |
| $(Sr,Ca)AlSiN_3:Eu^{2+}$ | 95 | 95 | 627 | 88 |
| $CaAlSiN_3:Eu^{2+}$ | 98 | 95 | 651 | 90 |

In general, the degree of temperature quenching of many phosphors is correlated with the wavelength conversion efficiency level of phosphors, in which manufacturing conditions are optimized. Therefore, as can be seen from Tables 1 and 2, a phosphor with the larger fluorescence intensity maintenance ratio tends to exhibit the higher internal quantum efficiency.

In the tables, several phosphors are confirmed in which the fluorescence intensity maintenance ratio is small, but the internal quantum efficiency is high. This is due to the difference in the mode of temperature quenching properties. A phosphor with temperature quenching properties, in which a fluorescence intensity rapidly decreases at about 100°C or higher, exhibits the high internal quantum efficiency at a room temperature, such as a temperature of 30°C, for example, and data is obtain in which a fluorescence intensity at 150°C is small. In other words, a phosphor with the high internal quantum efficiency at a room temperature does not necessarily have to have the small temperature quenching (large maximum fluorescence intensity), but a phosphor with the small temperature quenching can be expected to have the high internal quantum efficiency level.

As can be seen by comparing Tables 1 and 2, the fluorescence intensity maintenance ratio of many near-infrared phosphors shown in Table 1 is small, compared to that of visible phosphors shown in Table 2, and the majority of phosphors have large temperature quenching.

As a result of the investigation and evaluation performed by the inventors, the number of near-infrared phosphors, in which the fluorescence intensity maintenance ratio at a phosphor temperature of 150°C is more than 90%, is very small, and the near-infrared phosphors are $Ca_3Sc_2Si_3O_{12}:Cr^{3+}$ and $LiGa_5O_8:Cr^{3+}$ shown in Table 1. Suppose that, from the phosphors, the following are further selected: a near-infrared phosphor which has a fluorescence peak in a wavelength region of more than 800 nm, or a near-infrared phosphor which emits fluorescent light in which an FWHM is more than 180 nm. In the above case, a phosphor corresponding to such a phosphor is limited only to $LiGa_5O_8:Cr^{3+}$ with unexpectedly discovered fluorescence characteristics. Therefore, $LiGa_5O_8:Cr^{3+}$ as a near-infrared phosphor of the present disclosure is regarded as a near-infrared phosphor with exceptional fluorescence characteristics.

Fluorescent light of the $LiGa_5O_8:Cr^{3+}$ near-infrared phosphor having a maximum fluorescence intensity in a wavelength region of more than 800 nm, especially the vicinity of a wavelength region of 850 nm, has a form relatively similar to the spectral distribution of a halogen lamp. Therefore, the use of this kind of near-infrared fluorescence component is suitable for the purpose of replacing a halogen lamp which emits much heat. In recent years, it has been found that irradiation of harvested fruits and vegetables with near-infrared light with a wavelength in the vicinity of 850 nm for only a short period of time, can suppress deterioration in freshness and decay thereafter, and enhance the quality of the fruits and vegetables such as maintaining vitamin C, suppressing softening, and maintaining gloss. Therefore, fluorescent light of the $LiGa_5O_8:Cr^{3+}$ near-infrared phosphor is suitable for maintaining the freshness of the fruits and vegetables as described above.

Meanwhile, the $LiGa_5O_8:Cr^{3+}$ near-infrared phosphor according to one embodiment emits an ultra-wideband near-infrared component in which the fluorescent spectrum half width is more than 180 nm. Therefore, it is possible to obtain a near-infrared component which has the spectral distribution over a wide wavelength range of 700 to 1000 nm using only one kind of near-infrared phosphor. This reduces the necessity to use a plurality of kinds of near-infrared components with different fluorescence peak wavelengths, and is suitable for simplifying the technology.

The reason why, many of near-infrared phosphors, especially near-infrared phosphors which emit especially long-wavelength near-infrared components, exhibit relatively large temperature quenching, and the reason why the $LiGa_5O_8:Cr^{3+}$ near-infrared phosphor exhibits the above-described exceptional fluorescence characteristics, remain unclear. For the unclear reasons, the academic cause investigation in the future is desired. One of hypotheses is that an equilibrium position of the excited state of a fluorescent ion tends to be close to the ground state, as described at the beginning.

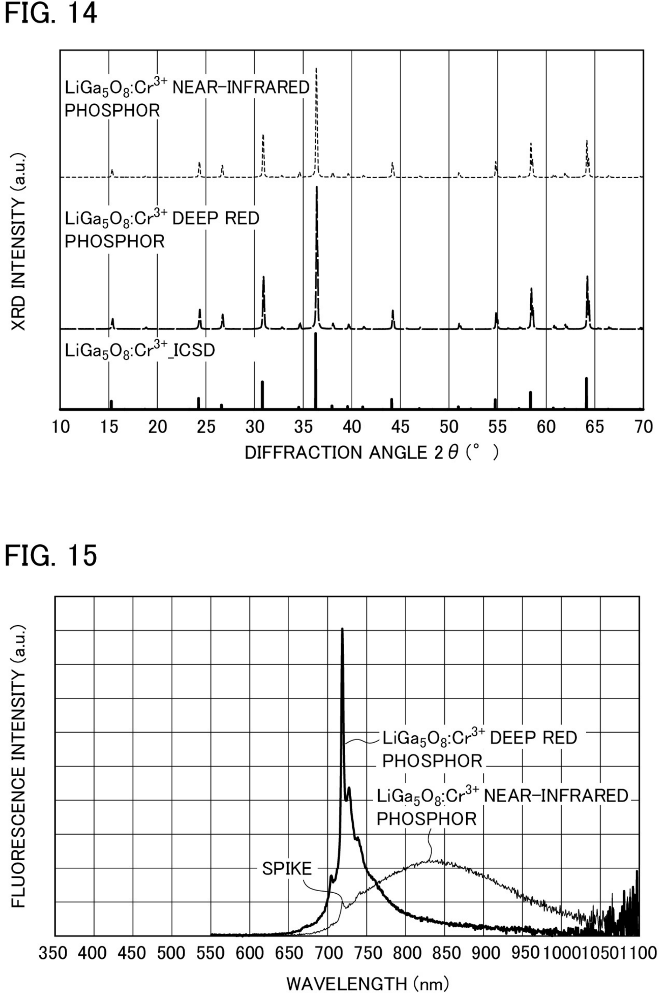

The near-infrared fluorescent light 21 or a near-infrared fluorescence component may have a spike in a wavelength range of 710 nm or more and 730 nm or less. This kind of spike is generally observed in a fluorescent spectrum of the $LiGa_5O_8:Cr^{3+}$ near-infrared phosphor exhibiting unique fluorescence characteristics, although the reason is unclear. In other words, a near-infrared phosphor emitting fluorescent light with this kind of spike may have very small temperature quenching. Meanwhile, the near-infrared fluorescent light 21 or the near-infrared fluorescence component may not have the spike in a wavelength range of 710 nm or more and 730 nm or less. Alternatively, even if the near-infrared fluorescent light 21 or the near-infrared fluorescence component has the spike, when a maximum fluorescence intensity in a wavelength range of 800 nm or more and 860 nm or less is assumed to be $I_{NIR}$, and a maximum intensity of the spike is assumed to be $I_{DR}$, it is preferable that $I_{DR}$ is less than two times of $I_{NIR}$. The spike refers to a sharp peak in the vicinity of a wavelength of 720 nm, as shown in FIG. 15, for example. When the spectral distribution is spectral data in increments of 1 nm, the spectral data of the spike changes by more than 7%/nm in a wavelength range, for example. The above-described near-infrared phosphor emits fluorescent light, in which the ratio of near-infrared components with wavelengths longer than a wavelength of 800 nm is large. This kind of near-infrared phosphor is more suitable for the near-infrared light emitting devices 100 for infrared spectroscopy. The $I_{DR}$ may be less than 1.25 times of $I_{NIR}$, less than 1.0 times of $I_{NIR}$, or less than 0.8 times of $I_{NIR}$.

The near-infrared phosphor may be a $Cr^{3+}$ activated phosphor, and the visible phosphor may be at least one phosphor of $Eu^{2+}$ activated alkaline earth metal nitride silicate and $Eu^{2+}$ activated alkaline earth metal nitride alumino-silicate. The $Cr^{3+}$ activated phosphor tends to have an excitation peak (absorption peak) in an orange-red wavelength region of 600 nm or more and less than 650 nm. Further, the $Eu^{2+}$ activated alkaline earth metal nitride silicate and the $Eu^{2+}$ activated alkaline earth metal nitride aluminosilicate tend to have fluorescence peaks in an orange-red wavelength region of 600 nm or more and less than 650 nm. Therefore, this kind of form leads to the near-infrared light emitting device 100.

The near-infrared light emitting device 100 is advantageous in keeping the ratio of light components absorbed by the near-infrared phosphor constant, when a wavelength of a fluorescent spectrum of the visible phosphor shifts to a long wavelength due to the temperature rise, and the near-infrared light emitting device 100 is advantageous in suppressing a change in the spectral distribution due to the temperature rise.

The wavelength converter 2 may include a resin fluorescent film, a fluorescent ceramic, a composite, or the like. The composite may include at least one of a resin fluorescent film and a fluorescent ceramic. The wavelength converter 2 may include an inorganic compound in an amount of 95% by mass or more, in an amount of 99% by mass or more, or in an amount of 100% by mass. The wavelength converter 2 with the high ratio of inorganic compounds has excellent thermal conductivity, and therefore it is possible to enhance heat dissipation.

The resin fluorescent film may have particulate phosphors dispersed in a resin. The resin fluorescent film can be formed by curing a phosphor paste which is obtained by mixing a resin and powdered phosphors, for example. As the resin, a translucent resin can be used, and an example of the resin is a silicone resin. The fluorescent ceramic may be a molded product formed by molding phosphors. The fluorescent ceramic can be formed by applying pressure, heating, and reaction sintering phosphor raw materials or phosphor powders, for example.

The wavelength converter 2 may contain fluorescent ceramics. The wavelength converter 2 may mainly contain fluorescent ceramics. The wavelength converter 2 mainly containing fluorescent ceramics means that the wavelength converter 2 contains fluorescent ceramics in an amount of 75% by weight or more. The wavelength converter 2 may contain fluorescent ceramics in an amount of 90% by weight or more.

The fluorescent ceramics may mainly contain near-infrared phosphors. The fluorescent ceramics mainly containing near-infrared phosphors means that the fluorescent ceramics contain near-infrared phosphors in an amount of 75% by weight or more. The fluorescent ceramics may contain near-infrared phosphors in an amount of 90% by weight or more, or in an amount of 100% by weight. Among phosphors to be used, a phosphor with the largest temperature quenching may be at least used as a fluorescent ceramic. In this way, it is possible to achieve the excellent thermal conductivity, and also enhance the light absorption rate of excitation light. This is advantageous for heat dissipation design and achieving high output, especially high output of a near-infrared component, and this is advantageous for achieving high output of a fluorescence component emitted by a phosphor with large temperature quenching.

The output light 20 includes a visible fluorescence component and a near-infrared fluorescence component. The visible fluorescence component has a spectral intensity in a wavelength range of visible light. The near-infrared fluorescence component has a spectral intensity in a wavelength range of near-infrared light.

The output light 20 may have a spectral intensity at least over an entire wavelength range of 700 nm or more and 1000 nm or less. The near-infrared light emitting device 100 emitting this kind of output light 20 is suitable for detecting or analyzing characteristic absorption bands of N-H stretching vibration, C-H stretching vibration, and O-H stretching vibration by means of a spectroscopy.

It is preferable that the output light 20 does not have the above-described spike. Specifically, it is preferable that the spectral distribution in a wavelength range of 700 nm or more and 1000 nm or less changes smoothly, relative to the wavelength. Therefore, it is possible to provide the near-infrared light emitting device 100 which can suppress the occurrence of measurement errors and analysis errors at a specific wavelength, which enables acquisition of highly reliable evaluation data, and which is advantageous for near-infrared spectroscopy. More specifically, when the spectral distribution is spectral data in increments of 1 nm, it is preferable that the spectral data does not change by more than 7%/nm, especially by more than 5%/nm, within a wavelength range of 700 nm or more and 1000 nm or less.

The output light 20 may have a spectral peak in at least a wavelength range of 800 nm or more and 900 nm or less, especially in a wavelength range of 800 nm or more and 860 nm or less. A spectral peak of this kind of output light 20 in a near-infrared wavelength region is similar to that of a halogen lamp. Therefore, it becomes relatively easy to use components and included software of a conventional spectroscopic apparatus using a halogen lamp. Accordingly, spectroscopic apparatuses can be industrially produced without major design changes. Further, in recent years, it has been found that irradiation of harvested fruits and vegetables with near-infrared light with a wavelength in the vicinity of 850 nm, for only a short period of time, can suppress deterioration in freshness and decay thereafter, and enhance the quality of the fruits such as maintaining vitamin C, suppressing softening, and maintaining gloss. Therefore, the near-infrared light emitting device 100 according to the present embodiment is advantageous for maintaining the freshness of fruits and vegetables as described above.

The half width of a spectrum having a maximum fluorescence intensity in a wavelength range of 800 nm or more and less than 900 nm, may be more than 180 nm. Therefore, it is possible to obtain a near-infrared component having the spectral distribution over a wide wavelength range. Accordingly, the near-infrared light emitting device 100 is suitable for near-infrared spectroscopy.

The near-infrared light emitting device 100 is configured to satisfy the relationship of $0.853 M_{VIS} \leq M_{NIR} < 1.147 M_{VIS}$. Here, $M_{VIS}$ is the ratio of $I_{max-VIS-150}$ to $I_{max-VIS-30}$ ($I_{max-VIS-150}/I_{max-VIS-30}$). The $M_{VIS}$ represents the visible light intensity maintenance ratio. The $I_{max-VIS-30}$ is a maximum fluorescence intensity of a visible fluorescence component when the temperature of the wavelength converter 2 is 30°C. The $I_{max-VIS-150}$ is a maximum fluorescence intensity of a visible fluorescence component when the temperature of the wavelength converter 2 is 150°C. The $M_{NIR}$ is the ratio of $I_{max-NIR-150}$ to $I_{max-NIR-30}$ ($I_{max-NIR-150}/I_{max-NIR-30}$). The $M_{NIR}$ represents the near-infrared intensity maintenance ratio. The $I_{max-NIR-30}$ is a maximum fluorescence intensity of a near-infrared fluorescence component when the temperature of the wavelength converter 2 is 30°C. The $I_{max-NIR-150}$ is a maximum fluorescence intensity of a near-infrared fluorescence component when the temperature of the wavelength converter 2 is 150°C.

In other words, a near-infrared phosphor having a small temperature quenching difference from a visible phosphor, is used in combination with the visible phosphor. As a result, even when time elapses after the near-infrared light emitting device 100 is turned on, and the temperature of the wavelength converter 2 rises, the amount of change in the intensity ratio between a visible fluorescence component and a near-infrared fluorescence component is small. Therefore, the spectral distribution of the output light 20 is stable. The near-infrared light emitting device 100 may be configured to satisfy the relationship of preferably $0.90M_{VIS} \leq M_{NIR} < 1.10M_{VIS}$, and more preferably $0.95M_{VIS} \leq M_{NIR} < 1.05M_{VIS}$.

It is preferable that $M_{NIR}$ is more than 90%. That is, even when the temperature of the wavelength converter 2 rises, the decrease in a fluorescence intensity of a near-infrared fluorescence component is small. This kind of wavelength converter 2 can be obtained by using a near-infrared phosphor, which has the small temperature quenching and has the fluorescence intensity maintenance ratio of more than 90% when a phosphor temperature is 150°C.

It is preferable that $M_{VIS}$ is more than 90%. That is, even when the temperature of the wavelength converter 2 rises, the decrease in a fluorescence intensity of a visible fluorescence component is small. This kind of wavelength converter 2 can be obtained by using phosphors shown in Table 2, which have the small temperature quenching and have the fluorescence intensity maintenance ratio of more than 90%, such as phosphors for LED lighting, for example.

It is preferable that both of $M_{NIR}$ and $M_{VIS}$ are more than 90%. In this case, even when the temperature of the wavelength converter 2 rises, there is little decrease in the intensity of the output light 20. Therefore, achievement of even higher output of the output light 20 can be expected. This kind of near-infrared light emitting device 100 is further suitable for a spectroscopy. Specifically, this kind of near-infrared light emitting device 100 can evaluate the quality of objects such as fruits and vegetables with high accuracy and in a non-destructive manner, for example. Further, this kind of near-infrared light emitting device 100 can be applied to maintain the freshness of fruits and vegetables by irradiating the fruits and vegetables with near-infrared light, or to evaluate the quality of materials with uneven body colors.

The near-infrared light emitting device 100 according to the present embodiment can be widely used for a non-destructive inspection using a spectroscopy, especially for evaluation of the quality of fruits and vegetables. The near-infrared light emitting device 100 can be used as a near-infrared light source which achieves reduction in size and high performance, for example.

As described above, the near-infrared light emitting device 100 according to the present embodiment includes the solid-state light emitting element 1 and the wavelength converter 2. The wavelength converter 2 includes the visible phosphor and the near-infrared phosphor. The visible phosphor emits the visible fluorescent light 22 having a maximum fluorescence intensity in a wavelength range of visible light. The near-infrared phosphor emits the near-infrared fluorescent light 21 having a maximum fluorescence intensity in a wavelength range of near-infrared light. The near-infrared light emitting device 100 emits the output light 20 including the visible fluorescent light and the near-infrared fluorescent light 21. The output light 20 includes the visible fluorescence component and the near-infrared fluorescence component. The visible fluorescence component has a spectral intensity in a wavelength range of visible light, and the near-infrared fluorescence component has a spectral intensity in a wavelength range of near-infrared light. The near-infrared light emitting device 100 is configured to satisfy the relationship of $0.853M_{VIS} \leq M_{NIR} < 1.147M_{VIS}$. The $M_{VIS}$ is the ratio of $I_{max-VIS-150}$ to $I_{max-VIS-30}$. The $I_{max-VIS-30}$ is a maximum fluorescence intensity of a visible fluorescence component when the temperature of the wavelength converter 2 is 30°C. The $I_{max-VIS-150}$ is a maximum fluorescence intensity of a visible fluorescence component when the temperature of the wavelength converter 2 is 150°C. The $M_{NIR}$ is the ratio of $I_{max-NIR-150}$ to $I_{max-NIR-30}$. The $I_{max-NIR-30}$ is a maximum fluorescence intensity of a near-infrared fluorescence component when the temperature of the wavelength converter 2 is 30°C. The $I_{max-NIR-150}$ is a maximum fluorescence intensity of a near-infrared fluorescence component when the temperature of the wavelength converter 2 is 150°C.

Even if a conventional near-infrared light emitting device attempts to evaluate the quality of fruits and vegetables in a non-destructive manner using a visible phosphor and a near-infrared phosphor thereof, the temperature of the phosphors rises due to the solid-state light emitting element 1 being turned on, and due to this, there is a risk that the intensity of a near-infrared fluorescence component decreases, relative to the intensity of a visible fluorescence component, for example. Therefore, there has been a problem that high-precision evaluation of the quality may not be expected within a short period of time after the conventional near-infrared light emitting device is turned on.

Meanwhile, the near-infrared light emitting device 100 according to the present embodiment is configured to satisfy the relationship of $0.853M_{VIS} \leq M_{NIR} < 1.147M_{VIS}$. Therefore, even when time elapses after the near-infrared light emitting device 100 is turned on, and the temperature of the wavelength converter 2 rises, the amount of change in the intensity ratio between a visible fluorescence component and a near-infrared fluorescence component is small. Accordingly, a change in the shape of the spectral distribution due to the temperature rise of the wavelength converter 2 of the near-infrared light emitting device 100 is small.

[Spectroscopic apparatus and spectroscopy]

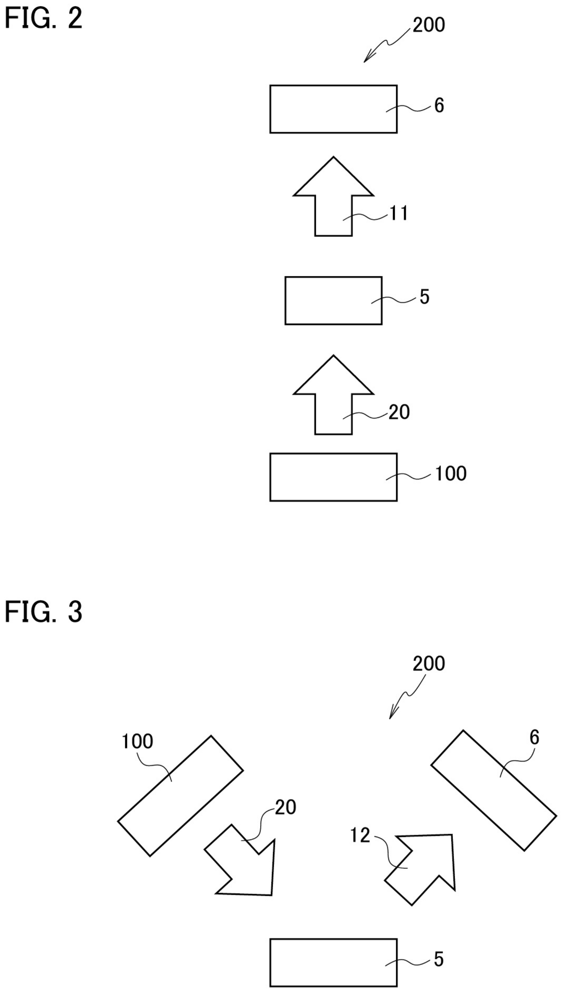

Next, with reference to FIGS. 2 and 3, a spectroscopic apparatus 200 and a spectroscopy according to the present embodiment will be described. The spectroscopic apparatus 200 is a near-infrared spectroscopy apparatus, for example. The spectroscopy is a near-infrared spectroscopy, for example. FIG. 2 is a schematic diagram showing an example of a transmission type spectroscopic apparatus 200. FIG. 3 is a schematic diagram showing an example of a reflection type spectroscopic apparatus 200. As shown in FIGS. 2 and 3, the spectroscopic apparatus 200 includes the near-infrared light emitting device 100. That is, the spectroscopic apparatus 200 relates to the spectroscopy using the near-infrared light emitting device 100.

As shown in FIG. 2, the transmission type spectroscopic apparatus 200 includes the near-infrared light emitting device 100 and a spectroscope 6. An object 5 to be inspected is interposed between the near-infrared light emitting device 100 and the spectroscope 6. The near-infrared light emitting device 100 is configured to emit the output light 20. The object 5 to be inspected is arranged such that the object 5 to be inspected is irradiated with the output light 20. The spectroscope 6 is arranged to receive transmitted light 11, which has passed through the inside of the object 5 to be inspected, especially near-infrared transmitted light, out of the output light 20 used to irradiate the object 5 to be inspected. The spectroscope 6 detects and disperses the transmitted light 11. The spectroscope 6 may be a near-infrared spectroscope, for example. The spectroscopic apparatus 200 may be an inspection apparatus. The inspection apparatus may analyze spectral data dispersed by the spectroscope 6. The inspection apparatus may include an analysis unit (not shown), and may apprehend or determine whether inspection items such as the internal state and the quality of the object 5 to be inspected are favorable using the analysis unit. The analysis unit may include a Central Processing Unit (CPU), a Read Only Memory (ROM), and a Random Access Memory (RAM). The CPU may read a program and reference data stored in the ROM, and perform information processing related to the analysis of the inspection items according to the program.

As shown in FIG. 3, the reflection type spectroscopic apparatus 200 also includes the near-infrared light emitting device 100 and the spectroscope 6. However, in the reflection type spectroscopic apparatus 200, the spectroscope 6 is arranged to receive reflected light 12, which has been reflected by the object 5 to be inspected, especially near-infrared reflected light, out of the output light 20 used to irradiate the object 5 to be inspected. Configurations other than the above of the reflection type spectroscopic apparatus 200 are similar to those of the transmission type spectroscopic apparatus 200, and therefore description thereof will be omitted.

The reflection type spectroscopic apparatus 200 may include a reflective member (not shown), such as a metal plate, particularly a reflective member for near-infrared light. Suppose that a near-infrared fluorescence component of the output light 20 which has passed through the object 5 to be inspected is reflected by the reflective member, and again passes through the inside of the object 5 to be inspected. In the above case, even if the object 5 to be inspected is a liquid or the like, it is possible to obtain near-infrared spectral data specific to the object 5 to be inspected without difficulty.

It is sufficient if the transmitted light 11 and the reflected light 12 have at least near-infrared fluorescence components. Depending on a form of the object 5 to be inspected, a visible fluorescence component can be either transmitted or reflected. In a form in which a visible component is reflected, the visible component may be dispersed, or may be used for a visual inspection of the object 5 to be inspected.

The object 5 to be inspected may be food. The term "food" is a general term for articles eaten by humans, such as lunch boxes ingredients, grains, fruits and vegetables, meat, fish, processed foods, and beverages.

The spectroscopic apparatus 200 can also be used as a foreign matter inspection apparatus for inspecting whether the object 5 to be inspected contains a foreign matter. The spectroscopic apparatus 200 can be used for detecting whether a foreign matter is mixed in food and conditions, for example. Further, the spectroscopic apparatus 200 can also be used as an inspection apparatus other than the foreign matter inspection apparatus, such as a quality control apparatus for evaluating the quality of fruits and vegetables, for example. The spectroscopic apparatus 200 can evaluate or measure the sugar content, acidity, internal fault, or the like of fruits and vegetables by inspecting the transmission amount of near-infrared light used to irradiate the fruits and vegetables. Therefore, this kind of spectroscopic apparatus 200 is suitable for quality control of fruits and vegetables.

In this way, the spectroscopic apparatus 200 uses at least a near-infrared component included in the output light 20. The spectroscopic apparatus 200 may detect a characteristic absorption band of at least one stretching vibration selected from the group consisting of N-H, C-H, and O-H, for example. In other words, the spectroscopic apparatus 200 may be configured to obtain near-infrared spectral data such as the characteristic absorption band. Since the spectroscopic apparatus 200 detects the characteristic absorption band as analysis data, the spectroscopic apparatus 200 can be used for a wide range of usage applications and is highly versatile. Therefore, the spectroscopic apparatus 200 is preferable.

As described above, the spectroscopic apparatus 200 includes the near-infrared light emitting device 100. Further, the near-infrared light emitting device 100 is used for the spectroscopy. As described above, the near-infrared light emitting device 100 has a small change in the shape of the spectral distribution due to the temperature rise of the wavelength converter 2. Therefore, a change in the shape of the spectral distribution due to the temperature rise of the wavelength converter 2 is also small in the spectroscopic apparatus 200 and the spectroscopy. The spectroscopic apparatus 200 and the spectroscopy of the present embodiment can be widely used for a foreign matter inspection and a quality inspection.

In the above embodiment, spectrums of the spectral distribution of the output light 20, the near-infrared fluorescent light 21, and the visible fluorescent light 22 may be spectrums when a wavelength of the primary light 10 (excitation light) is 450 nm, unless otherwise stated. Further, the spectrums may be spectrums at 30°C, unless otherwise stated. Specifically, the spectrums may be spectrums when the temperature of a phosphor or the wavelength converter is 30°C.

[Examples]

The present embodiment will be described in additional detail below by means of examples, but the present embodiment is not limited to these examples. The evaluation was performed at 30°C, unless otherwise stated.

(Example 1)

A near-infrared light emitting device (wavelength conversion type light emitting device) having a solid-state light emitting element and a wavelength converter was fabricated using the following members 1) to 4).

1) Solid-state light emitting element
High-power blue LED (actual peak wavelength: 460 nm) (product number: SMBB450H-1100, Ushio Inc.)

2) Wavelength converter

2-1) $CaAlSiN_3:Eu^{2+}$ (CASN) red phosphor (fluorescence peak wavelength: 651 nm) (Mitsubishi Chemical Corporation)

2-2) $LiGa_5O_8:Cr^{3+}$ (LGO) near-infrared phosphor (fluorescence peak wavelength: 833 nm) (fabricated by means of a method which will be described later)

2-3) Two-liquid mixing type of thermosetting silicone resin (sealing material for LED, product name: KER-2600A/B, Shin-Etsu Chemical Co., Ltd.)

(Fabrication of wavelength converter)

A wavelength converter was fabricated by laminating a first wavelength converter (one CASN red phosphor sheet) and a second wavelength converter (two LGO near-infrared phosphor sheets), which were fabricated as follows.

(Fabrication of first wavelength converter)

0.68 g of a CASN red phosphor and a silicone resin (1 g of KER-2600A, 1 g of KER-2600B) were mixed using a stirring defoaming device, and then further defoamed. The stirring defoaming device used at this time was manufactured by THINKY CORPORATION, the product name was AWATORI RENTARO (registered trademark), and the model was ARE-310. Further, the rotational speed of the stirring defoaming device was approximately 2000 rpm, and processing was performed for 3 minutes. In this way, a phosphor paste containing the CASN red phosphor and the silicone resin was prepared. The phosphor paste thus obtained was dropped into a frame having a height of approximately 140 $\mu$m using a dispenser (model: ML-5000 XII, manufactured by Musashi Engineering, Inc.). Then, the phosphor paste was cured by heating in the atmosphere at 150°C for 2 hours. In this way, a resin fluorescent film having a thickness of approximately 130 $\mu$m (CASN red phosphor sheet: 10 mm long * 10 mm wide) was formed, and the first wavelength converter was obtained.

(Fabrication of second wavelength converter)

First, the $LiGa_5O_8:Cr^{3+}$ near-infrared phosphor was synthesized by means of the following procedures. The following compound powders were prepared as raw materials.

1) Lithium carbonate ($Li_2CO_3$): purity 2N, manufactured by FUJIFILM Wako Pure Chemical Corporation

2) Gallium oxide ($Ga_2O_3$): purity 4N, manufactured by Nippon Rare Metal, Inc.

3) Chromium oxide ($Cr_2O_3$): purity 3N, manufactured by Kojundo Chemical Laboratory Co., Ltd.

The above raw materials were weighed and prepared to achieve a compound with a composition of $Li(Ga_{0.97}Cr_{0.03})_5O_8$, that is, to achieve the desired ratio of metal elements. The prepared raw materials were dry-mixed using a mortar and a pestle to obtain a mixed raw material. The above mixed raw material was put in an alumina crucible with a lid, and calcined in the atmosphere of 1500°C for 4 hours using a box-type electric furnace. The calcined product obtained by calcining was lightly crushed to obtain the $LiGa_5O_8:Cr^{3+}$ (LGO) near-infrared phosphor. Characteristics of the LGO near-infrared phosphor will be described later.

Next, similarly to the first wavelength converter, 0.40 g of a LGO near-infrared phosphor and a silicone resin (1 g of KER-2600A, 1 g of KER-2600B) were mixed using a stirring defoaming device, and then further defoamed. In this way, a phosphor paste containing the LGO near-infrared phosphor and the silicone resin was prepared. The phosphor paste thus obtained was dropped into a frame having a height of approximately 320 μm using the dispenser. Then, the phosphor paste was cured by heating in the atmosphere at 150°C for 2 hours. In this way, a resin fluorescent film having a thickness of approximately 300 μm (LGO near-infrared phosphor sheet: 10 mm long * 10 mm wade) was formed, and the second wavelength converter was obtained.

(Fabrication of near-infrared light emitting device)

A phosphor sheet was arranged on a principal light extraction surface of a blue LED such that the blue LED faces the second wavelength converter of the laminated wavelength converters, and accordingly the near-infrared light emitting device as shown in FIG. 1 was fabricated.

Light emission characteristics of the obtained near-infrared light emitting device were evaluated. When a current of 10 mA (2.6 V) was applied to a blue LED chip, blue light as primary light was radiated from the blue LED chip. Then, a part of the primary light was converted into a near-infrared fluorescence component by the second wavelength converter. In addition, a part of the primary light passed through the second wavelength converter, was converted into red light as a visible fluorescence component by the first wavelength converter. Then, the near-infrared light emitting device emitted, as output light, mixed light of the blue light as the primary light, the near-infrared fluorescence component, and the visible fluorescence component. For reference, the appearance of the output light was violet light, and the light had a color tone which may not be regarded as white light. The violet light is regarded as light produced by additive color mixing of a blue light component of the primary light, and red light components of the near-infrared fluorescence component and the visible fluorescence component.

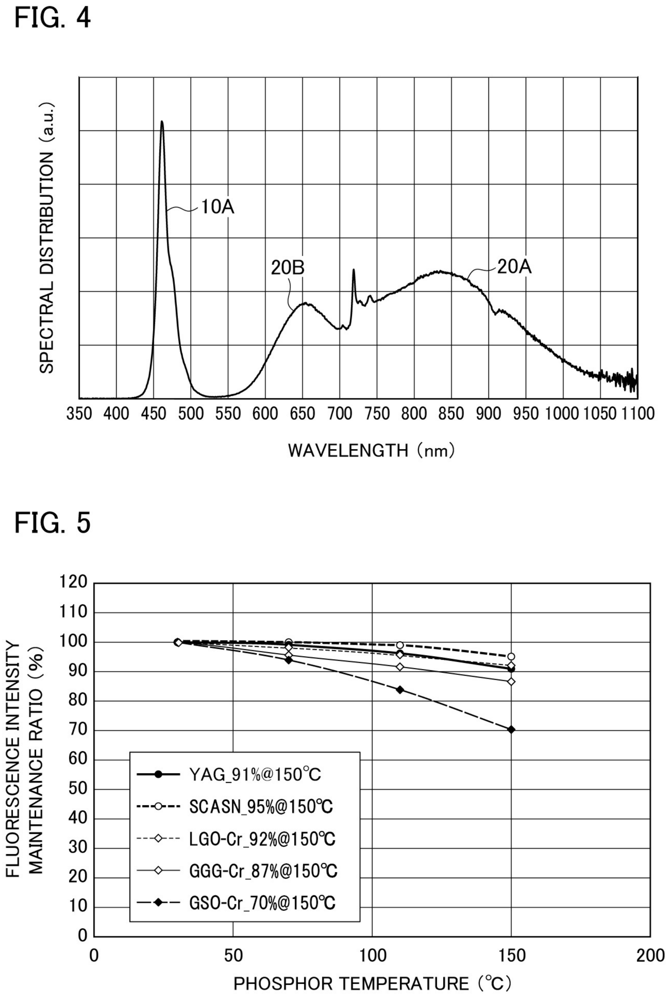

FIG. 4 shows the spectral distribution of the output light emitted from the near-infrared light emitting device of the present embodiment. As can be seen from FIG. 4, the spectral distribution of the output light mainly includes a light component 10A derived from the primary light, a light component 20A derived from the near-infrared phosphor of the second wavelength converter, and a light component 20B derived from the visible phosphor of the first wavelength converter.

As can be seen from FIG. 4, by using only one kind of near-infrared phosphor, it was possible to obtain output light having a maximum fluorescence intensity in the vicinity of a wavelength of 830 nm. Further by using only one kind of near-infrared phosphor, it was possible to obtain output light which has not only a spectral intensity in a wide wavelength range of 700 nm or more and less than 1000 nm, but also a relatively strong spectral intensity in a wavelength range of 700 nm or more and less than 950 nm. In addition, by using the near-infrared phosphor in combination with a CASN red phosphor as the visible phosphor, it was possible to obtain a near-infrared light emitting device which emits output light that has a spectral intensity all over a wavelength range of 570 nm or more and less than 1000 nm and has a small intensity change rate relative to a wavelength.

As shown in Tables 1 and 2, the temperature quenching of both of the LGO near-infrared phosphor and the CASN red phosphor is small, the near-infrared intensity maintenance ratio ($M_{NIR}$) is 92%, which is more than 90%, and the visible light intensity maintenance ratio ($M_{VIS}$) is 98%. Therefore, in the near-infrared light emitting device, $M_{VIS}$ and $M_{NIR}$ satisfy the following relationship: $0.853 M_{vis} (\approx 0.836) \leq M_{NIR} (\approx 0.920) < 1.147 M_{VIS} (= 1.124)$.

Therefore, even if the temperature of the wavelength converter rises due to the near-infrared light emitting device being turned on, a change in the shape of a spectrum of wavelength converted light by a phosphor is small, and the wavelength converted light is located on a longer wavelength side than a wavelength of about 490 nm. In this way, it was possible to configure the near-infrared light emitting device which is suitable for the spectroscopy. For example, the near-infrared light emitting device can be expected to perform a high-precision quality evaluation of fruits and vegetables within a short period of time after being turned on in a non-destructive measurement of the fruits and vegetables, for example.

If a component is only a wavelength converted light component by a phosphor, even if the near-infrared light emitting device is not configured, these mixed phosphors can be used to evaluate the shape of a spectrum of the output light emitted by the near-infrared light emitting device which uses a fluorescent film including the visible phosphor and the near-infrared phosphor. For a change in a spectrum of the wavelength converted light component due to the temperature rise of the fluorescent film, it is sufficient if temperature dependence of fluorescent light of the mixed phosphors is investigated. Therefore, the temperature dependence of fluorescent spectrums of several mixed phosphors formed by mixing visible phosphors and near-infrared phosphors was simply evaluated.

(Examples 2 to 7 and Comparative Examples 1 and 2)

Table 3 summarizes visible phosphors and near-infrared phosphors used for the evaluation. Further, for reference, FIG. 5 shows the temperature quenching of these phosphors.

[Table 3]

| Classification | Abbreviation | General formula | Fluorescence intensity maintenance ratio (%) | Remarks |
|---|---|---|---|---|
| Visible phosphor | YAG | $Y_3Al_2(AlO_4)_3:Ce^{3+}$ | 91% | Commercially available product |
| Visible phosphor | SCASN | $(Sr,Ca)AlSiN_3:Eu^{2+}$ | 95% | Commercially available product |
| Near-infrared phosphor | LGO | $LiGa_5O_8:Cr^{3+}$ | 92% | Self-produced product |
| Near-infrared phosphor | GGG | $Gd_3Ga_2(GaO_4):Cr^{3+}$ | 87% | Commercially available product |
| Near-infrared phosphor | GSO | $(Ga,Sc)_2O_3:Cr^{3+}$ | 70% | Commercially available product |

Next, mixed phosphors according to Examples 2 to 7 and Comparative Examples 1 and 2 were fabricated according to blending shown in Table 4.

[Table 4]

| | Mixed phosphor | Weight ratio | |
|---|---|---|---|
| | | Visible phosphor | Near-infrared phosphor |
| Example 2 | SCASN + LGO | 1 | 10 |
| Example 3 | SCASN + LGO | 1 | 3 |
| Example 4 | YAG + LGO | 1 | 10 |
| Example 5 | YAG + LGO | 1 | 3 |
| Example 6 | SCASN + GGG | 1 | 3 |
| Example 7 | YAG + GGG | 1 | 3 |
| Comparative Example 1 | SCASN + GSO | 1 | 3 |
| Comparative Example 2 | YAG + GSO | 1 | 3 |

In order to indicate the temperature dependence of the mixed phosphors, the evaluation was made for fluorescent spectrums when the temperature of the mixed phosphors was changed from 30°C to 270°C in increments of 40°C. A wavelength of excitation light for exciting the mixed phosphors was set to be 450 nm.

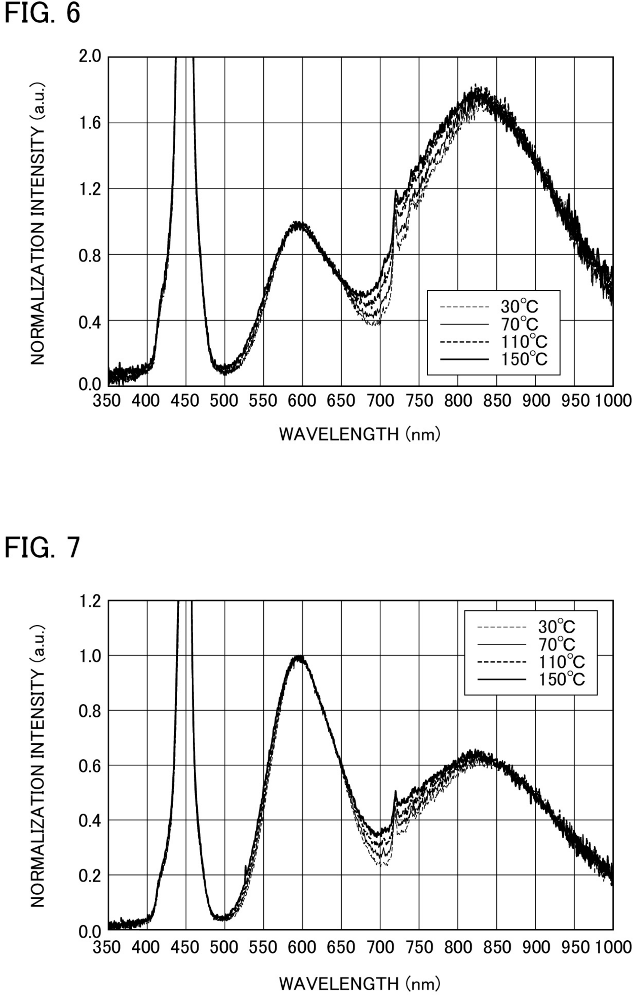

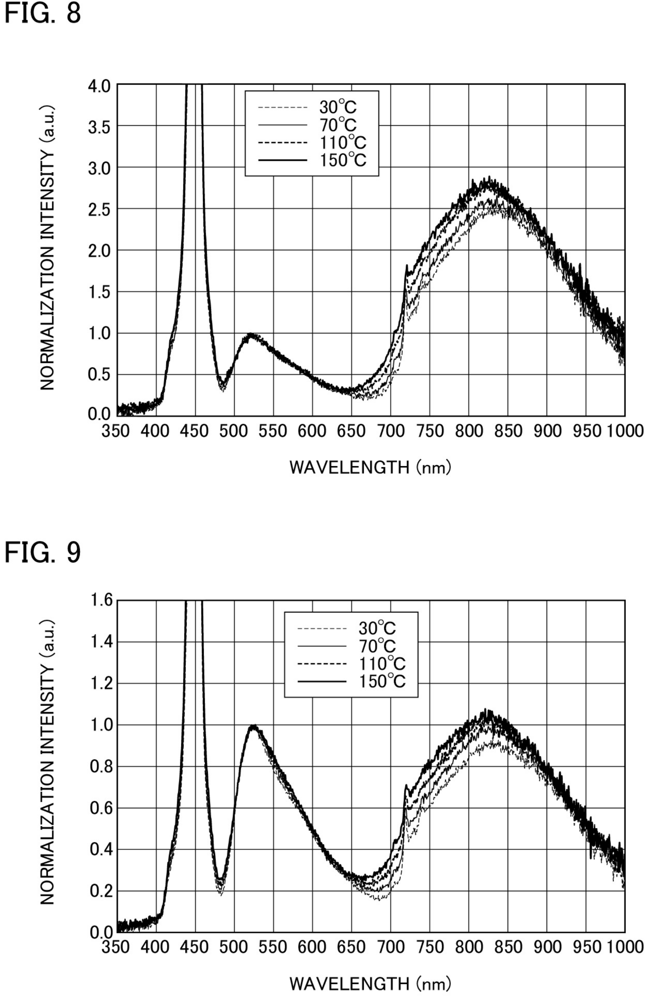

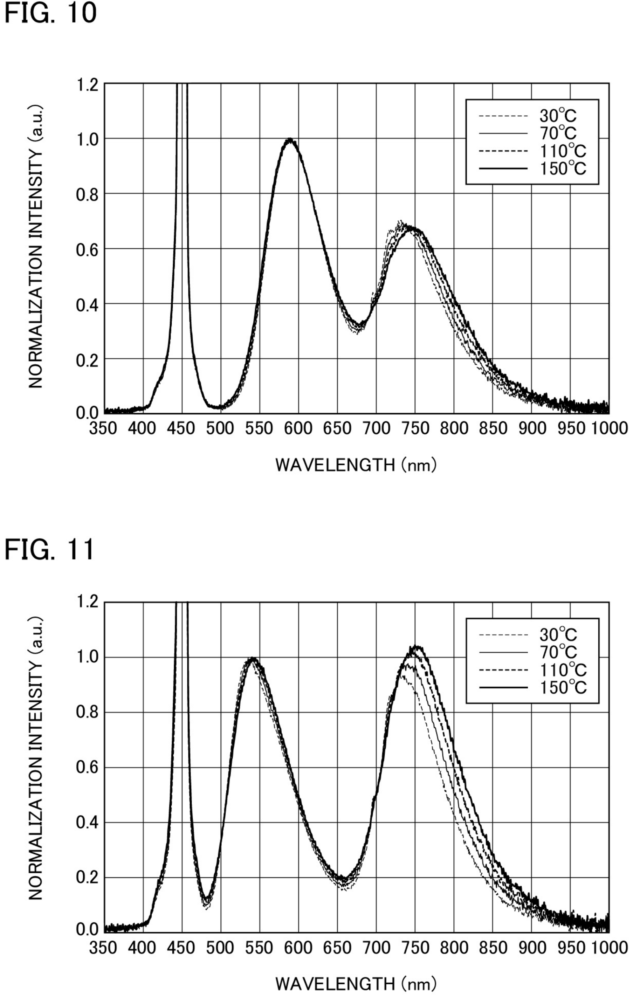

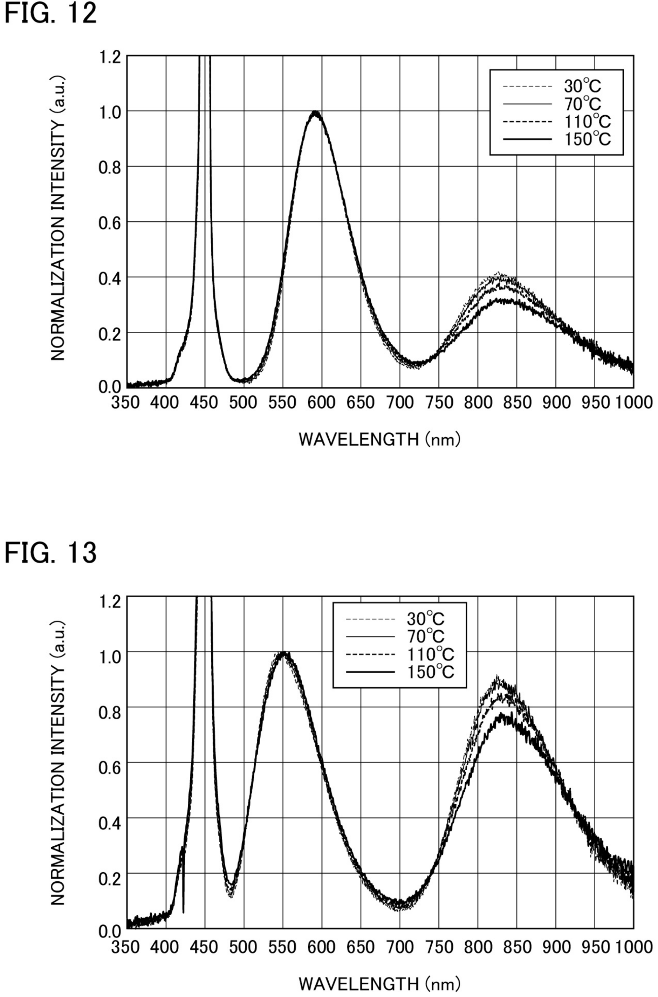

FIG. 6 shows fluorescent spectrums of mixed phosphors according to Example 2 at each temperature. FIG. 7 shows fluorescent spectrums of mixed phosphors according to Example 3 at each temperature. FIG. 8 shows fluorescent spectrums of mixed phosphors according to Example 4 at each temperature. FIG. 9 shows fluorescent spectrums of mixed phosphors according to Example 5 at each temperature. FIG. 10 shows fluorescent spectrums of mixed phosphors according to Example 6 at each temperature. FIG. 11 shows fluorescent spectrums of mixed phosphors according to Example 7 at each temperature. FIG. 12 shows fluorescent spectrums of mixed phosphors according to Comparative Example 1 at each temperature. FIG. 13 shows fluorescent spectrums of mixed phosphors according to Comparative Example 2 at each temperature.

In order to visualize a change in the shape of the spectral distribution, all pieces of data are spectral data normalized by a maximum fluorescence intensity of a visible phosphor. In the drawings, spectral data in the vicinity of a wavelength of 450 nm is a leakage component of excitation light.

The following tendencies are observed from FIGS. 6 to 13.

(1) In mixed phosphors according to Comparative Example 1 and Comparative Example 2, in which a visible phosphor with small temperature quenching is mixed with a near-infrared phosphor with large temperature quenching, a decrease in a near-infrared component intensity due to the temperature rise is observed.

(2) In mixed phosphors according to Examples 2 to 7, in which a visible phosphor with small temperature quenching is mixed with a near-infrared phosphor with small temperature quenching, a visible component intensity and a near-infrared component intensity due to the temperature rise are almost unchanged, or a slight increase in the near-infrared component intensity is observed.

(3) When a case where a visible phosphor is a $Ce^{3+}$ activated garnet phosphor (Examples 4, 5, and 7) is compared with a case where a visible phosphor is a $Eu^{2+}$ activated nitride-based phosphor (Examples 2, 3, and 6), a change in a spectrum due to the temperature rise is smaller in the latter case. Table 5 summarizes the situations. In Table 5, "150°C/30°C" corresponds to $M_{NIR}/M_{VIS}$.

[Table 5]

| | | Near-infrared fluorescence peak height when visible fluorescence peak height is one | | | | Relative intensity at 150°C normalized by intensity at 30°C | |
|---|---|---|---|---|---|---|---|
| | | 30°C | 70°C | 110°C | 150°C | 150°C/30°C | Inrease and decrease rate |
| SCASN1+LGO10 | Example 2 | 1.767 | 1.772 | 1.834 | 1.805 | 1.021 | 0.021 |
| SCASN1+LGO3 | Example 3 | 0.631 | 0.651 | 0.661 | 0.655 | 1.038 | 0.038 |
| YAG1+LGO10 | Example 4 | 2.564 | 2.657 | 2.841 | 2.889 | 1.127 | 0.127 |
| YAG1+LGO3 | Example 5 | 0.939 | 1.020 | 1.038 | 1.077 | 1.147 | 0.147 |
| SCASN1+GGG3 | Example 6 | 0.702 | 0.691 | 0.686 | 0.677 | 0.963 | -0.037 |
| YAG1+GGG3 | Example 7 | 0.938 | 0.977 | 1.018 | 1.044 | 1.113 | 0.113 |
| SCASN1+GSO3 | Comparative Example 1 | 0.420 | 0.402 | 0.379 | 0.322 | 0.768 | -0.232 |
| YAG1+GSO3 | Comparative Example 2 | 0.918 | 0.900 | 0.855 | 0.781 | 0.851 | -0.149 |

In other words, in order to suppress a change in the spectral distribution of the output light due to the temperature rise, it was found that it is effective for the near-infrared light emitting device to satisfy the relation of $0.853M_{VIS} \leq M_{NIR} < 1.147M_{VIS}$. The above relation is especially effective for a change in the spectral distribution in a wavelength range of 600 nm or more and 980 nm or less, which is effective for precise evaluation of fruits and vegetables. Further, the following combinations of phosphors were found to be more preferable.

(1) A combination of a visible phosphor and a near-infrared phosphor with a small temperature quenching difference.

(2) A combination of a $Eu^{2+}$ activated red phosphor and a $Cr^{3+}$ activated near-infrared phosphor.

The reason why the following result was obtained is considered to be due to effects below: the combination of the $Eu^{2+}$ activated red phosphor and the $Cr^{3+}$ activated near-infrared phosphor was effective in suppressing a change in the spectral distribution of the output light due to temperature rise. In other words, the $Cr^{3+}$ activated near-infrared phosphor tends to have an excitation peak (absorption peak) in an orange-red wavelength region of 600 nm or more and less than 650 nm, and the $Eu^{2+}$ activated red phosphor tends to have a fluorescence peak in an orange-red wavelength region of 600 nm or more and less than 650 nm. Therefore, even if a wavelength of a fluorescent spectrum of a visible phosphor slightly shifts to a long wavelength due to the temperature rise, a wavelength of an excitation peak of the near-infrared phosphor also slightly shifts to a long wavelength. Therefore, the ratio of light components absorbed by the near-infrared phosphor does not change significantly due to the temperature rise of phosphors.

In order to suppress a decrease in an intensity of the output light due to the temperature rise, it is preferable to use a phosphor having a small absolute value of temperature quenching. If the combination of phosphors, in which intensities of near-infrared components decrease due to the temperature rise, is compared with the combination of phosphors, in which intensities of near-infrared components increase, it is preferable to use the latter combination.

Next, a $LiGa_5O_8:Cr^{3+}$ deep red phosphor was synthesized and evaluated for comparison with the $LiGa_5O_8:Cr^{3+}$ near-infrared phosphor synthesized in Example 1.

(Synthesis of $LiGa_5O_8:Cr^{3+}$ deep red phosphor)

The phosphor was fabricated in the same manner as the $LiGa_5O_8:Cr^{3+}$ near-infrared phosphor of Example 1, except that the calcination temperature was 1200°C.

(Evaluation of $LiGa_5O_8:Cr^{3+}$ phosphor)

First, an X-ray diffraction pattern was measured by means of an X-ray diffraction method using a desktop X-ray diffraction device, MiniFlex 600 (manufactured by Rigaku Corporation). A crystal phase of a compound constituting the phosphor was identified by comparison with a diffraction pattern of a data registered compound crystal.

FIG. 14 shows X-ray diffraction patterns of the $LiGa_5O_8:Cr^{3+}$ near-infrared phosphor and the $LiGa_5O_8:Cr^{3+}$ deep red phosphor, and an X-ray diffraction pattern of $LiGa_5O_8$ registered in an inorganic crystal structure database (ICSD). As can be seen from FIG. 14, the XRD pattern of the $LiGa_5O_8:Cr^{3+}$ near-infrared phosphor exhibited the same pattern as the XRD pattern of the $LiGa_5O_8:Cr^{3+}$ deep red phosphor. This revealed that the $LiGa_5O_8:Cr^{3+}$ near-infrared phosphor had a crystal with the same atomic arrangement as a compound $LiGa_5O_8$.

Next, a fluorescent spectrum, temperature quenching, and internal quantum efficiency of a phosphor when excited at an excitation wavelength of 450 nm were evaluated using Quantaurus-QY Plus (expansion type, an absolute PL quantum yield spectrometer with heating mechanism) C13534-02 (manufactured by Hamamatsu Photonics K.K.).

FIG. 15 shows fluorescent spectrums of the $LiGa_5O_8:Cr^{3+}$ near-infrared phosphor and the $LiGa_5O_8:Cr^{3+}$ deep red phosphor. As shown in Table 1, the fluorescent spectrum of the $LiGa_5O_8:Cr^{3+}$ near-infrared phosphor had a maximum fluorescence intensity in the vicinity of a wavelength of 833 nm. Further, the fluorescent spectrum of the $LiGa_5O_8:Cr^{3+}$ near-infrared phosphor had a fluorescence component over a wide wavelength range of 700 to 1100 nm. Still further, as shown in Table 1, an FWHM of the fluorescent spectrum of the $LiGa_5O_8:Cr^{3+}$ near-infrared phosphor was 214 nm, which was more than 200 nm, and the spectrum was wide. Meanwhile, the fluorescent spectrum of the $LiGa_5O_8:Cr^{3+}$ deep red phosphor had an emission line maximum fluorescence intensity in the vicinity of a wavelength of 715 to 720 nm, and an FWHM thereof was 4 nm. In this way, the fluorescent spectrum of the $LiGa_5O_8:Cr^{3+}$ near-infrared phosphor was significantly different from a fluorescent spectrum of a conventional $LiGa_5O_8:Cr^{3+}$ deep red phosphor.

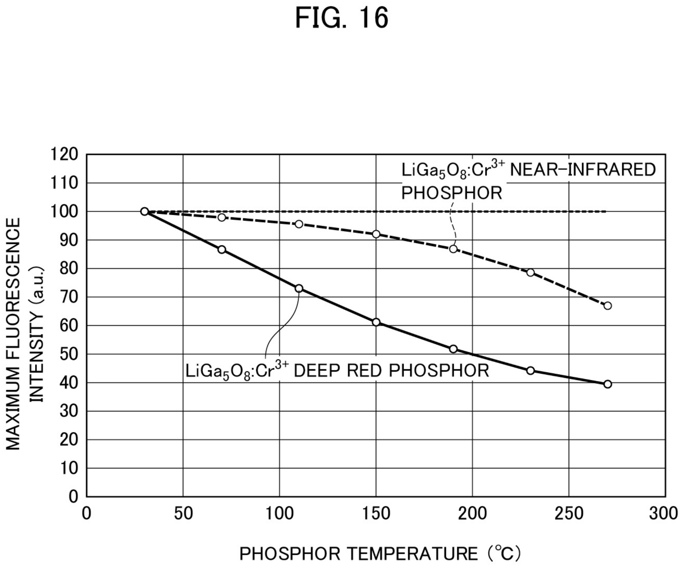

FIG. 16 is the graph showing the relationship between the temperature of the $LiGa_5O_8:Cr^{3+}$ near-infrared phosphor and $LiGa_5O_8:Cr^{3+}$ deep red phosphor, and maximum fluorescence intensities (temperature quenching properties) emitted by the phosphors. As shown in Table 1 also, the fluorescence intensity maintenance ratio of the $LiGa_5O_8:Cr^{3+}$ near-infrared phosphor was 92%, which was more than 90%, and the temperature quenching was very small. Meanwhile, the fluorescence intensity maintenance ratio of the $LiGa_5O_8:Cr^{3+}$ deep red phosphor was 61%.

As shown in Table 1, the $LiGa_5O_8:Cr^{3+}$ near-infrared phosphor had the internal quantum efficiency of 85%, while the $LiGa_5O_8:Cr^{3+}$ deep red phosphor had the internal quantum efficiency of 54%. It was found that the internal quantum efficiency of the $LiGa_5O_8:Cr^{3+}$ near-infrared phosphor was more than 80%, even though the phosphor experimentally produced was in an early stage of development.

Finally, in order to enhance the accuracy of composition information related to the difference between the $LiGa_5O_8:Cr^{3+}$ near-infrared phosphor and the $LiGa_5O_8:Cr^{3+}$ deep red phosphor, main component compositions of the phosphors were analyzed to obtain results. The composition ratio of Li, Ga, and Cr, which were main components of the phosphors, was quantitatively evaluated by means of inductively coupled plasma emission spectrometry (ICP-AES) using iCAP7400 Duo (manufactured by Thermo Fisher Scientific K.K.).

As a result, a composition of the deep red phosphor was $Li_{0.94}(Ga_{0.75}Cr_{0.03})_5O_{8-\alpha}$, while a composition of the near-infrared phosphor was $Li_{0.81}(Ga_{0.75}Cr_{0.03})_5O_{8-\alpha}$. It was found that the $LiGa_5O_8:Cr^{3+}$ near-infrared phosphor had a composition in which Li is clearly deficient relative to a stoichiometric composition of $Li(Ga_{1-x}Cr_x)_5O_8$. From these results, it was found that if the amount of Li is small, relative to the stoichiometric composition, a phosphor functions as a near-infrared phosphor.

For reference, a hypothesis will be described below in which the $LiGa_5O_8:Cr^{3+}$ near-infrared phosphor exhibits exceptional fluorescence characteristics as described above.

It can be considered that the $LiGa_5O_8:Cr^{3+}$ near-infrared phosphor is a clearly Li deficient composition, relative to the stoichiometric composition. Nevertheless, the phosphor has substantially the same crystal structure as the $LiGa_5O_8:Cr^{3+}$ deep red phosphor. When these are considered, there is a possibility that the crystal structure of the $LiGa_5O_8:Cr^{3+}$ near-infrared phosphor is maintained by valence change of a part of $Ga^{3+}$ to $Ga^+$.

In other words, in the hypothesis, a crystal which is supposed to have a form of $LiGa(III)_3(GaO_4)_2$, has a form of $X(LiGa(I)Ga(III)_2(GaO_4)_2)$ (however, X is a numerical value satisfying $0 < X <1$), and the crystal structure of $LiGa_5O_8$ is maintained. In this form, $Cr^{3+}$ (first $Cr^{3+}$) for replacing a lattice position of $Ga^{3+}$ that changes in valence to $Ga^+$, is not able to avoid being present at or in the vicinity of a lattice position of $Ga^+$, while retaining charge distortion. Due to the effect, there is a possibility that the shape of a spectrum is changed and light is observed as broad light.

A maximum fluorescence intensity (wavelength: about 718 nm) of $Cr^{3+}$ (second $Cr^{3+}$), which replaces a lattice position of $Ga^{3+}$ that does not change in valence to $Ga^+$, is on the shorter wavelength side than a maximum fluorescence intensity (wavelength: about 830 nm) of first $Cr^{3+}$. Therefore, it is not possible to deny the possibility that first $Cr^{3+}$ absorbs emission line light emitting components of second $Cr^{3+}$. Meanwhile, it is known that $Cr^{3+}$ does not usually adopt 4-coordination structure. Therefore, it is estimated that in a crystal of $X(LiGa(I)Ga(III)_2(GaO_4)_2)$, $Cr^{3+}$ exists at lattice positions of Ga(I) and Ga(III) other than a Ga lattice position of $(GaO_4)$.

The ratio of Ga(I) : Ga(III) is 1 : 2. Therefore, the relative number of moles of first $Cr^{3+}$ for replacing the Ga lattice positions is considered to be large, and is about half of those of second $Cr^{3+}$. Therefore, it is not possible to deny the possibility that efficient energy transfer from second $Cr^{3+}$ (emission line light emission) to first $Cr^{3+}$ is generated. Due to this kind of energy transfer, the emission line light emission by second $Cr^{3+}$ is hardly observed, and there is a possibility that a broad light emitting component by first $Cr^{3+}$ has superior fluorescent spectrum shape.

In addition, considering that first $Cr^{3+}$ exists, while retaining charge distortion, it is not possible to deny the possibility that ground and excited states have deep potential wells. Assuming that such electronic states are formed, these electronic states may not easily change positions thereof, unless high energy is obtained. Therefore, the non-emission transition from the excited state to the ground state is unlikely to occur, and the fluorescence efficiency may be exhibited, which is high at even high temperature and is similar to that at room temperature.

Information that many near-infrared phosphors exhibit relatively large temperature quenching is an essential issue of near-infrared phosphors, and this may be due to optical properties.

Fluorescent light of a near-infrared phosphor is fluorescent light which is converted to near-infrared light after the near-infrared phosphor absorbs blue light, for example. Therefore, the fluorescent light becomes wavelength converted light which has a larger Stokes shift (the energy difference between light absorption and fluorescence emission) than fluorescent light of a visible phosphor. This means that wavelength converted light is obtained, which is due to the electron energy transition with a larger Franck-Condon offset (shift of equilibrium position between ground state and excited state). Therefore, it is estimated that an equilibrium position of an excited state of a fluorescent ion (for example, $Cr^{3+}$) of a near-infrared phosphor tends to be close to a ground state. Since fluorescence transition is performed in such a form, there is a possibility that temperature quenching easily occurs.

The self-produced $LiGa_5O_8:Cr^{3+}$ near-infrared phosphor may have an exceptional fluorescent spectrum and temperature quenching properties, because $Cr^{3+}$ is placed under such a special environment in a $LiGa_5O_8$ crystal.

(Supplementary notes)

By the above description of the embodiments, the following techniques are disclosed.

(Technique 1) A near-infrared light emitting device including: a solid-state light emitting element; and a wavelength converter that includes a visible phosphor which emits visible fluorescent light having a maximum fluorescence intensity in a wavelength range of visible light, and a near-infrared phosphor which emits near-infrared fluorescent light having a maximum fluorescence intensity in a wavelength range of near-infrared light, in which the near-infrared light emitting device emits output light including the visible fluorescent light and the near-infrared fluorescent light, the output light includes a visible fluorescence component having a spectral intensity in a wavelength range of visible light, and a near-infrared fluorescence component having a spectral intensity in a wavelength range of near-infrared light, the near-infrared light emitting device is configured to satisfy a relationship of $0.853M_{VIS} \leq M_{NIR} < 1.147M_{VIS}$, the $M_{VIS}$ is a ratio of $I_{max-VIS-150}$ to $I_{max-VIS-30}$, the $I_{max-VIS-30}$ is a maximum fluorescence intensity of the visible fluorescence component when a temperature of the wavelength converter is 30°C, the $I_{max-VIS-150}$ is a maximum fluorescence intensity of the visible fluorescence component when a temperature of the wavelength converter is 150°C, the $M_{NIR}$ is a ratio of $I_{max-NIR-150}$ to $I_{max-NIR-30}$, the $I_{max-NIR-30}$ is a maximum fluorescence intensity of the near-infrared fluorescence component when a temperature of the wavelength converter is 30°C, and the $I_{max-NIR-150}$ is a maximum fluorescence intensity of the near-infrared fluorescence component when a temperature of the wavelength converter is 150°C.

Due to the configuration, even when time elapses after the near-infrared light emitting device is turned on, and the temperature of the wavelength converter rises, the amount of change in the intensity ratio between the visible fluorescence component and the near-infrared fluorescence component is small. Therefore, a change in the shape of the spectral distribution due to the temperature rise of the wavelength converter of the near-infrared light emitting device is small.

(Technique 2) The near-infrared light emitting device according to Technique 1, in which a half width of a spectrum with the maximum fluorescence intensity of the near-infrared fluorescent light is more than 180 nm. Due to the configuration, even if one kind of near-infrared phosphor is used and several kinds of near-infrared phosphors are not used, it is possible to obtain a near-infrared component having the spectral distribution over a wide wavelength range of 700 to 1000 nm. Therefore, it is possible to reduce a risk that the shape of the spectral distribution of the near-infrared fluorescent light or the near-infrared fluorescence component changes due to the temperature quenching difference when different kinds of near-infrared phosphors are used.

(Technique 3) The near-infrared light emitting device according to Technique 1 or 2, in which the near-infrared phosphor includes at least a chromium ion that functions as a fluorescent ion and that is added to a crystal of an inorganic compound with a spinel crystal structure which is the same as a spinel crystal structure of a compound $LiGa_5O_8$. Due to the configuration, a crystal with chemical properties similar to those of $LiGa_5O_8$ is used as the near-infrared phosphor. Therefore, the near-infrared phosphor is expected to have fluorescence characteristics similar to fluorescence characteristics of $LiGa_5O_8:Cr^{3+}$ which has been found to have a unique fluorescent spectrum shape and to exhibit temperature quenching. This is advantageous in combining the near-infrared phosphor with a visible phosphor with low temperature quenching. When application is made to a spectroscopy, high-precision non-destructive measurement can be expected.

(Technique 4) The near-infrared light emitting device according to any one of Techniques 1 to 3, in which the near-infrared fluorescent light includes a spike in a wavelength range of 710 nm or more and 730 nm or less. A near-infrared phosphor emitting fluorescent light with this kind of spike may have very small temperature quenching. Therefore, a near-infrared light emitting device having very small temperature quenching may be provided.

(Technique 5) The near-infrared light emitting device according to any one of Techniques 1 to 4, in which the visible phosphor is at least one phosphor selected from the group consisting of a green phosphor that emits light having a maximum fluorescence intensity in a wavelength range of 490 nm or more and less than 570 nm, a yellow phosphor that emits light having a maximum fluorescence intensity in a wavelength range of 570 nm or more and less than 585 nm, an orange phosphor that emits light having a maximum fluorescence intensity in a wavelength range of 585 nm or more and less than 620 nm, and a red phosphor that emits light having a maximum fluorescence intensity in a wavelength range of 620 nm or more and less than 780 nm. Due to the configuration, it is possible to adjust the spectral distribution of a visible fluorescence component. Therefore, it is possible to adjust a visible fluorescence component of the output light emitted from the near-infrared light emitting device according to a usage application.

(Technique 6) The near-infrared light emitting device according to any one of Techniques 1 to 5, in which the visible phosphor is at least one phosphor selected from the group consisting of a $Ce^{3+}$ activated garnet phosphor, $Eu^{2+}$ activated alkaline earth metal nitride silicate, and $Eu^{2+}$ activated alkaline earth metal nitride aluminosilicate. These visible phosphors have high application achievements as phosphors for LED lighting. Therefore, procurement of these visible phosphors is easy, and additionally reliability and handling of these visible phosphors are assured.

(Technique 7) The near-infrared light emitting device according to any one of Techniques 1 to 6, in which the near-infrared phosphor is a $Cr^{3+}$ activated phosphor, and the visible phosphor is at least one phosphor of $Eu^{2+}$ activated alkaline earth metal nitride silicate and $Eu^{2+}$ activated alkaline earth metal nitride aluminosilicate. This kind of near-infrared light emitting device is advantageous in keeping the ratio of light components absorbed by the near-infrared phosphor constant, when a wavelength of a fluorescent spectrum of the visible phosphor shifts to a long wavelength due to the temperature rise. This is advantageous in suppressing a change in the spectral distribution due to the temperature rise.

(Technique 8) The near-infrared light emitting device according to any one of Techniques 1 to 7, in which the wavelength converter includes a fluorescent ceramic. Due to the configuration, the wavelength converter has excellent thermal conductivity, and also the light absorption rate of excitation light is enhanced. This is advantageous for heat dissipation design and achieving high output.

(Technique 9) The near-infrared light emitting device according to any one of Techniques 1 to 8, in which the visible phosphor and the near-infrared phosphor are excited by primary light emitted by the solid-state light emitting element. Due to the configuration, a visible phosphor and a near-infrared phosphor can be excited using only one type of solid-state light emitting element. This is advantageous in simplifying a lighting circuit.

(Technique 10) The near-infrared light emitting device according to any one of Techniques 1 to 9, in which the output light has a spectral intensity at least over an entire wavelength range of 700 nm or more and 1000 nm or less. This kind of output light includes light components of characteristic absorption bands of N-H stretching vibration, C-H stretching vibration, and O-H stretching vibration. Therefore, this kind of near-infrared light emitting device is suitable for detecting characteristic absorption bands of N-H stretching vibration, C-H stretching vibration, and O-H stretching vibration by means of a spectroscopy.

(Technique 11) The near-infrared light emitting device according to any one of Techniques 1 to 10, in which the output light includes a spectral peak in at least a wavelength range of 800 nm or more and 900 nm or less. A spectral peak of this kind of output light in a near-infrared wavelength region is similar to that of a halogen lamp. Therefore, it becomes relatively easy to use components and included software of a conventional spectroscopic apparatus using a halogen lamp.

Therefore, spectroscopic apparatuses can be industrially produced without major design changes.

(Technique 12) A spectroscopic apparatus including: the near-infrared light emitting device according to any one of Techniques 1 to 11. This kind of spectroscopic apparatus uses the near-infrared light emitting device, which has a small change in the shape of the spectral distribution due to the temperature rise of the wavelength converter. Therefore, it is possible to provide the spectroscopic apparatus which enables a high-precision spectroscopy.

(Technique 13) A spectroscopy using the near-infrared light emitting device according to any one of Techniques 1 to 11. This kind of spectroscopy uses the near-infrared light emitting device, which has a small change in the shape of the spectral distribution due to the temperature rise of the wavelength converter. Therefore, it is possible to provide a high-precision spectroscopy.

The entire contents of Japanese Patent Application No. 2023-010886 (filed on: January 27, 2023) are incorporated herein by reference.

Although the contents of the embodiments herein have been described above in accordance with examples, it is obvious to those skilled in the art that the embodiments herein are not limited to the descriptions thereof and that various modifications and improvements are possible within the scope of the gist of the embodiments herein.

INDUSTRIAL APPLICABILITY

According to the present disclosure, it is possible to provide a near-infrared light emitting device, which has a small change in the shape of the spectral distribution due to the temperature rise of a wavelength converter, and a spectroscopic apparatus and a spectroscopy which use the near-infrared light emitting device.

REFERENCE SIGNS LIST

1      Solid-state light emitting element

2      Wavelength converter

10     Primary light

20     Output light

21     Near-infrared fluorescent light

22     Visible fluorescent light

100    Near-infrared light emitting device

200    Spectroscopic apparatus

**Claims**

1.  A near-infrared light emitting device comprising:

    a solid-state light emitting element; and
    a wavelength converter that includes a visible phosphor which emits visible fluorescent light having a maximum fluorescence intensity in a wavelength range of visible light, and a near-infrared phosphor which emits near-infrared fluorescent light having a maximum fluorescence intensity in a wavelength range of near-infrared light, wherein
    the near-infrared light emitting device emits output light including the visible fluorescent light and the near-infrared fluorescent light,
    the output light includes a visible fluorescence component having a spectral intensity in a wavelength range of visible light, and a near-infrared fluorescence component having a spectral intensity in a wavelength range of near-infrared light,
    the near-infrared light emitting device is configured to satisfy a relationship of

$$0.853M_{VIS} \leq M_{NIR} < 1.147M_{VIS},$$

the $M_{VIS}$ is a ratio of $I_{max\text{-}VIS\text{-}150}$ to $I_{max\text{-}VIS\text{-}30}$,
the $I_{max\text{-}VIS\text{-}30}$ is a maximum fluorescence intensity of the visible fluorescence component when a temperature of the wavelength converter is 30°C,
the $I_{max\text{-}VIS\text{-}150}$ is a maximum fluorescence intensity of the visible fluorescence component when a temperature of the wavelength converter is 150°C,
the $M_{NIR}$ is a ratio of $I_{max\text{-}NIR\text{-}150}$ to $I_{max\text{-}NIR\text{-}30}$,
the $I_{max\text{-}NIR\text{-}30}$ is a maximum fluorescence intensity of the near-infrared fluorescence component when a temperature of the wavelength converter is 30°C, and
the $I_{max\text{-}NIR\text{-}150}$ is a maximum fluorescence intensity of the near-infrared fluorescence component when a temperature of the wavelength converter is 150°C.

2. The near-infrared light emitting device according to claim 1, wherein
a half width of a spectrum with the maximum fluorescence intensity of the near-infrared fluorescent light is more than 180 nm.

3. The near-infrared light emitting device according to claim 1 or 2, wherein
the near-infrared phosphor includes at least a chromium ion that functions as a fluorescent ion and that is added to a crystal of an inorganic compound with a spinel crystal structure which is the same as a spinel crystal structure of a compound $LiGa_5O_8$.

4. The near-infrared light emitting device according to any one of claims 1 to 3, wherein
the near-infrared fluorescent light includes a spike in a wavelength range of 710 nm or more and 730 nm or less.

5. The near-infrared light emitting device according to any one of claims 1 to 4, wherein
the visible phosphor is at least one phosphor selected from the group consisting of a green phosphor that emits light having a maximum fluorescence intensity in a wavelength range of 490 nm or more and less than 570 nm, a yellow phosphor that emits light having a maximum fluorescence intensity in a wavelength range of 570 nm or more and less than 585 nm, an orange phosphor that emits light having a maximum fluorescence intensity in a wavelength range of 585 nm or more and less than 620 nm, and a red phosphor that emits light having a maximum fluorescence intensity in a wavelength range of 620 nm or more and less than 780 nm.

6. The near-infrared light emitting device according to any one of claims 1 to 5, wherein
the visible phosphor is at least one phosphor selected from the group consisting of a $Ce^{3+}$ activated garnet phosphor, $Eu^{2+}$ activated alkaline earth metal nitride silicate, and $Eu^{2+}$ activated alkaline earth metal nitride aluminosilicate.

7. The near-infrared light emitting device according to any one of claims 1 to 6, wherein
the near-infrared phosphor is a $Cr^{3+}$ activated phosphor, and the visible phosphor is at least one phosphor of $Eu^{2+}$ activated alkaline earth metal nitride silicate and $Eu^{2+}$ activated alkaline earth metal nitride aluminosilicate.

8. The near-infrared light emitting device according to any one of claims 1 to 7, wherein
the wavelength converter includes a fluorescent ceramic.

9. The near-infrared light emitting device according to any one of claims 1 to 8, wherein
the visible phosphor and the near-infrared phosphor are excited by primary light emitted by the solid-state light emitting element.

10. The near-infrared light emitting device according to any one of claims 1 to 9, wherein
the output light has a spectral intensity at least over an entire wavelength range of 700 nm or more and 1000 nm or less.

11. The near-infrared light emitting device according to any one of claims 1 to 10,
wherein
the output light includes a spectral peak in at least a wavelength range of 800 nm or more and 900 nm or less.

12. A spectroscopic apparatus comprising:
the near-infrared light emitting device according to any one of claims 1 to 11.

13. A spectroscopy using the near-infrared light emitting device according to any one of claims 1 to 11.

# FIG. 1

FIG. 2

200

6

11

5

20

100

FIG. 3

200

100

6

20

12

5

## FIG. 4

## FIG. 5

## FIG. 6

## FIG. 7

## FIG. 8

## FIG. 9

## FIG. 10

## FIG. 11

## FIG. 12

## FIG. 13

## FIG. 14

## FIG. 15

# FIG. 16

## INTERNATIONAL SEARCH REPORT

| International application No. |
| --- |
| **PCT/JP2023/046790** |

### A. CLASSIFICATION OF SUBJECT MATTER

*G02B 5/20*(2006.01)i; *C09K 11/08*(2006.01)i; *C09K 11/59*(2006.01)i; *C09K 11/62*(2006.01)i; *C09K 11/64*(2006.01)i; *C09K 11/80*(2006.01)i; *G01J 3/10*(2006.01)i; *G01N 21/01*(2006.01)i
FI: G02B5/20; G01J3/10; G01N21/01 D; C09K11/62; C09K11/59; C09K11/64; C09K11/08 J; C09K11/80

According to International Patent Classification (IPC) or to both national classification and IPC

### B. FIELDS SEARCHED

Minimum documentation searched (classification system followed by classification symbols)

G02B5/20; C09K11/08; C09K11/59; C09K11/62; C09K11/64; C09K11/80; G01J3/10; G01N21/01

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
| --- | --- | --- |
| X | CN 113357614 A (XUYU OPTOELECTRONICS (SHENZHEN) CO., LTD.) 07 September 2021 (2021-09-07) paragraphs [0004], [0038], [0039], [0043], [0088]-[0096] | 1, 5-9, 12-13 |
| Y | paragraphs [0004], [0038], [0039], [0043], [0088]-[0096] | 2-4, 10-11 |
| Y | JP 2021-101239 A (PANASONIC INTELLECTUAL PROPERTY MANAGEMENT CO., LTD.) 08 July 2021 (2021-07-08) paragraphs [0059], [0153]-[0164], fig. 8 | 2-4, 10-11 |
| A | CN 115595152 A (HANGZHOU DIANZI UNIVERSITY) 13 January 2023 (2023-01-13) paragraphs [0034]-[0036], fig. 1 | 1-13 |
| A | CN 113355095 A (SOUTH CHINA AGRICULTURAL UNIVERSITY) 07 September 2021 (2021-09-07) fig. 1 | 1-13 |

☑ Further documents are listed in the continuation of Box C.    ☑ See patent family annex.

| | | | |
| --- | --- | --- | --- |
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **26 February 2024** | **12 March 2024** |

| Name and mailing address of the ISA/JP | Authorized officer |
| --- | --- |
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (July 2022)

**INTERNATIONAL SEARCH REPORT**

International application No.

**PCT/JP2023/046790**

| C. | DOCUMENTS CONSIDERED TO BE RELEVANT | |
|---|---|---|
| Category* | Citation of document, with indication, where appropriate, of the relevant passages | Relevant to claim No. |
| A | WO 2020/217671 A1 (PANASONIC INTELLECTUAL PROPERTY MANAGEMENT CO., LTD.) 29 October 2020 (2020-10-29) paragraphs [0126]-[0135], [0141], [0144], fig. 12, 13 | 1-13 |

Form PCT/ISA/210 (second sheet) (July 2022)

## INTERNATIONAL SEARCH REPORT
### Information on patent family members

International application No.

**PCT/JP2023/046790**

| Patent document cited in search report | | | Publication date (day/month/year) | Patent family member(s) | | Publication date (day/month/year) |
|---|---|---|---|---|---|---|
| CN | 113357614 | A | 07 September 2021 | (Family: none) | | |
| JP | 2021-101239 | A | 08 July 2021 | US 2022/0090759 A1 paragraphs [0138]-[0144], [0180], fig. 16 EP 3904488 A1 CN 113227321 A | | |
| CN | 115595152 | A | 13 January 2023 | (Family: none) | | |
| CN | 113355095 | A | 07 September 2021 | (Family: none) | | |
| WO | 2020/217671 | A1 | 29 October 2020 | EP 3961827 A1 paragraphs [0126]-[0135], [0141], [0144], fig. 12, 13 CN 113711449 A | | |

Form PCT/ISA/210 (patent family annex) (July 2022)

**REFERENCES CITED IN THE DESCRIPTION**

**Patent documents cited in the description**

- WO 2020217671 A
- JP 2023010886 A